(19) Europäisches Patentamt
European Patent Office
Office européen des brevets

(11) EP 4 234 733 A1

(12) **EUROPÄISCHE PATENTANMELDUNG**

(43) Veröffentlichungstag:
**30.08.2023 Patentblatt 2023/35**

(21) Anmeldenummer: **22159089.6**

(22) Anmeldetag: **28.02.2022**

(51) Internationale Patentklassifikation (IPC):
**C22C 5/04** (2006.01)     **C22C 9/00** (2006.01)
**C22F 1/14** (2006.01)     **G01R 1/067** (2006.01)
**C22C 30/00** (2006.01)

(52) Gemeinsame Patentklassifikation (CPC):
**C22C 5/04; C22C 9/00; C22C 30/00; C22F 1/14;
G01R 1/06711**

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**
Benannte Erstreckungsstaaten:
**BA ME**
Benannte Validierungsstaaten:
**KH MA MD TN**

(71) Anmelder: **Heraeus Deutschland GmbH & Co. KG
63450 Hanau (DE)**

(72) Erfinder:
• **Fecher, Jonas
63450 Hanau (DE)**
• **Wegner, Matthias
63450 Hanau (DE)**

(74) Vertreter: **Heraeus IP
Heraeus Business Solutions GmbH
Intellectual Property
Heraeusstraße 12-14
63450 Hanau (DE)**

(54) **PALLADIUM-KUPFER-SILBER-LEGIERUNG**

(57)     Die Erfindung betrifft eine Palladium-Kupfer-Silber-Legierung bestehend aus 40 bis 58 Gew% Palladium, 25 bis 42 Gew% Kupfer, 6 bis 20 Gew% Silber, optional bis zu 6 Gew% zumindest eines Elements aus der Gruppe Ruthenium, Rhodium und Rhenium, und bis zu 1 Gew% Verunreinigungen, wobei die Palladium-Kupfer-Silber-Legierung eine kristalline Phase mit einer B2-Kristallstruktur enthält und 0 Vol% bis 10 Vol% Ausscheidungen von Silber, Palladium und binären Silber-Palladium-Verbindungen aufweist.

Die Erfindung betrifft auch einen Formkörper, einen Draht, ein Band oder eine Prüfnadel aus einer solchen Palladium-Kupfer-Silber-Legierung sowie die Verwendung einer solchen Palladium-Kupfer-Silber-Legierung zum Prüfen von elektrischen Kontakten oder zur elektrischen Kontaktierung oder zur Herstellung eines Schleifkontakts. Die Erfindung betrifft auch ein Verfahren zur Herstellung einer Palladium-Kupfer-Silber-Legierung.

Figur 11

EP 4 234 733 A1

**Beschreibung**

Die Erfindung betrifft eine Palladium-Kupfer-Silber-Legierung (PdCuAg-Legierung) und Formkörper aus einer solchen Palladium-Kupfer-Silber-Legierung, insbesondere einen Draht, ein Band oder eine Prüfnadel aus einer solchen Palladium-Kupfer-Silber-Legierung, die Verwendung einer solchen Palladium-Kupfer-Silber-Legierung zum Prüfen von elektrischen Kontakten oder zur elektrischen Kontaktierung oder zur Herstellung eines Schleifkontakts sowie ein Verfahren zur Herstellung einer Palladium-Kupfer-Silber-Legierung.

Während der Chipproduktion werden Wafer direkt nach der Prozessierung mit Prüfnadeln kontaktiert, um die Funktionsfähigkeit von integrierten Schaltungen (IC) in ungesägtem Zustand zu testen. Ein Array von Prüfnadeln testet dabei nach der Strukturierung der einzelnen Chips den Halbleiterwafer auf Funktionalität. Die Prüfnadeln sind in einer Testkarte (probe card) fixiert, die auf das Design des Wafers abgestimmt ist. Beim Prüfprozess wird der Wafer auf die Prüfnadeln gepresst und eine Kontaktierung zwischen Prüfnadeln und den Pads der ICs hergestellt, bei Aluminium Pads durch eine Passivierungsschicht hindurch hergestellt. Daraufhin werden verschiedene Parameter getestet, wie zum Beispiel die Kontaktierung, elektrische Kennwerte bei hoher Stromdichte und das elektrische Verhalten bei Temperaturwechseln. Prüfnadeln werden also bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1).

Die Schlüsselparamater einer guten Prüfnadel sind eine hohe elektrische Leitfähigkeit, da hierbei hohe elektrische Ströme übertragen werden müssen, sowie eine hohe Härte, um die Wartungsintervalle gering zu halten. Aktuell werden für sogenannte "Probe Needles" (Prüfnadeln) demzufolge Metalle oder Legierungen verwendet, die eine hohe elektrische und thermische Leitfähigkeit aber auch hohe Härten und Zugfestigkeiten besitzen. Dabei dient die elektrische Leitfähigkeit von reinem Kuper (100% IACS = 58,1 * $10^6$ S/m) als Referenz. Kupfer (Cu) und Silber (Ag) können zu diesen Zwecken jedoch nicht eingesetzt werden, da sie deutlich zu duktil sind und sich die Prüfnadel beim Einsatz verformen würde.

Neben Prüfnadeln profitieren aber auch andere Anwendungen, wie insbesondere Drähte für Schleifkontakte, von Materialien mit hohen elektrischen und thermischen Leitfähigkeiten und gleichzeitig guten mechanischen Eigenschaften, wie einer hohen Härte und Zugfestigkeit. Bei Schleifkontakten ist es wichtig, dass einerseits durch die Oberflächen ein geringer Übergangswiderstand verursacht wird und andererseits das Material sich nicht zu schnell abnutzt also abreibt oder erodiert.

Anwendungen wie Prüfnadeln (Probe Needles) oder Schleifdrähte in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung.

Typische Materialien für Prüfnadeln sind ausscheidungsgehärtete Palladium-Silber-Legierungen, die 10% Gold und 10% Platin enthalten können und beispielsweise unter den Produktnamen Paliney® 7, Hera 6321 und Hera 648 vertrieben werden. Diese Legierungen weisen eine hohe Härte von 400-500 HV auf. Die elektrische Leitfähigkeit ist mit 9-12 % IACS aber eher gering. Die hohe Leitfähigkeit ist ein entscheidender Faktor bei Prüfnadeln. Für das Testen auf Aluminiumpads sind Prüfnadeln aus den Materialien Wolfram, Wolframcarbid, Palladium-Kupfer-Silber-Legierungen und Wolfram-Rhenium weit verbreitet. Diese sind besonders hart, wobei Aluminiumpads robuster als Goldpads sind und einer Prüfung mit harten Nadeln besser standhalten können als Goldpads. Auch diese Prüfnadeln haben keine sehr hohe elektrische Leitfähigkeit. Legierungen mit höherer elektrischer Leitfähigkeit wie CuAg7 sind weniger hart (ca. 320 HV0,05) und weniger warmfest als Palladium-Silber-Legierungen oder Palladium-Kupfer-Silber-Legierungen.

Für die Anwendung auf Goldpads sind Palladium-Legierungen (Pd-Legierungen) bekannt, wie beispielsweise Paliney® H3C der Firma Deringer Ney oder NewTec® der Firma Advanced Probing. Bereits aus der US 1 913 423 A und der GB 354 216 A sind grundsätzlich geeignete Palladium-Kupfer-Silber-Legierungen bekannt. Palladium-Kupfer-Silber-Legierung können eine Struktur mit einem Übergitter ausbilden, die zu einer Verbesserung der elektrischen Leitfähigkeit und der mechanischen Stabilität der Legierung führt. Die Atome in dem Gitter sind dann nicht mehr statistisch zufällig verteilt, sondern sie ordnen sich in periodischen Strukturen, dem Übergitter an. Hierdurch sind Härten von mehr als 350 HV1 (Vickers Härteprüfung nach DIN EN ISO 6507-1:2018 bis -4:2018 mit einer Prüfkraft von 9,81 N (1 Kilopond)), elektrische Leitfähigkeiten von mehr als 19,5% IACS und Bruchfestigkeiten bis zu 1500 MPa möglich.

Die US 2014/377 129 A1 und die US 5 833 774 A sowie die nicht vorveröffentlichte europäische Patentanmeldung mit den Anmeldenummer EP 20 19 3903 offenbaren gehärtete Ag-Pd-Cu-Legierungen für elektrische Anwendungen. Derartige Palladium-Kupfer-Silber-Legierungen weisen eine elektrische Leitfähigkeit von etwa 9% bis 12% IACS und eine Härte von 400 bis 500 HV1 auf. Eine höhere elektrische Leitfähigkeit wäre wünschenswert. Die US 10 385 424 B2 offenbart eine Palladium-Kupfer-Silber-Legierung zusätzlich enthaltend bis zu 5 Gew% Rhenium. Diese Palladium-Kupfer-Silber-Legierung wird unter dem Produktnamen Paliney® 25 vertrieben. Hiermit kann die elektrische Leitfähigkeit deutlich erhöht werden und erreicht Werte von mehr als 19,5% IACS. Rhenium hat einen sehr hohen Schmelzpunkt von 3180 °C und muss daher aufwendig mit den anderen Metallen legiert werden. Oxide an der Oberfläche können die Funktion von Prüfnadeln und Schleifkontakten einschränken. Des Weiteren ist immer auch eine weitere Erhöhung der elektrischen Leitfähigkeit und/oder der Härte der Legierung für die Anwendung als Material für Prüfnadeln wünschenswert.

In Journal of Phys. Chem. Ref. Data, Vol. 6, No 3, 1977, Seiten 647 bis 650 sind Erkenntnisse zum ternären Phasendiagramm Cu-Ag-Pd zusammengefasst. Dort ist ausgeführt, dass keine ternäre Phase in dem ternären System Cu-Ag-Pd gefunden wurde. Es wird jedoch eine binäre Cu-Pd-Phase erwähnt, die als β'-Phase bezeichnet wird und die eine kubisch raumzentrierte B2-Kristallstruktur aufweist. Aus den Phasendiagrammen ergibt sich, dass die β'-Phase unter Normaldruck bei 400 °C bis zu einem Silbergehalt von 4 Gew% thermodynamisch stabil ist, wobei die PdCuAg-Legierung bei höherem Silbergehalt ein heterogenes Phasengemisch mit Silber-Palladium-Ausscheidungen bildet. Die maximale Härte wird bei einer Zusammensetzung von 25 Gew% Cu, 25 Gew% Ag und 50 Gew% Pd oder bei einer Zusammensetzung von 30 Gew% Cu, 30 Gew% Ag und 40 Gew% Pd angenommen.

Die Aufgabe der Erfindung besteht also darin, die Nachteile des Stands der Technik zu überwinden. Insbesondere soll eine Legierung sowie ein Formkörper, ein Draht, ein Band oder eine Prüfnadel bereitgestellt werden, die eine hohe elektrische Leitfähigkeit bei gleichzeitig hoher Härte aufweisen, die aber gleichzeitig einfach in der Herstellung sind und eine möglichst hohe Oxidationsbeständigkeit an der Oberfläche haben. Der Formkörper soll möglichst kostengünstiger herstellbar sein als vergleichbare Legierungen. Die Legierung und die Produkte sollen als Prüfnadeln zum Prüfen von elektrischen Kontaktierungen verwendbar sein.

Ziel der Erfindung ist es somit eine Legierung, wie die bekannten Palladium-Kupfer-Silber-Legierungen zu finden, die die mechanischen Eigenschaften (Härte, Streckgrenze, Federeigenschaften) bekannter Palladium-Kupfer-Silber-Legierung mit einer höheren elektrischen Leitfähigkeit verbindet. Derartige Palladium-Kupfer-Silber-Legierungen haben einen entscheidenden technischen Vorteil, insbesondere bei der Anwendung als Material für Prüfnadeln.

Eine weitere Aufgabe der Erfindung liegt darin einen Formkörper, insbesondere einen Draht, ein Band oder eine Prüfnadel, bereitzustellen, die die zuvor genannten Eigenschaften erfüllt. Ferner ist eine weitere Aufgabe in der Entwicklung eines Drahts für einen Schleifkontakt aufweisend mehrere Drähte aus einer solchen Legierung zu sehen.

Die Aufgaben der Erfindung werden gelöst durch eine Palladium-Kupfer-Silber-Legierung bestehend aus

(a) 40 bis 58 Gew% Palladium,
(b) 25 bis 42 Gew% Kupfer,
(c) 6 bis 20 Gew% Silber,

(d) optional bis zu 6 Gew% zumindest eines Elements, das aus der Gruppe ausgewählt ist, die aus Ruthenium, Rhodium und Rhenium besteht, und
(e) bis zu 1 Gew% Verunreinigungen,

wobei die Palladium-Kupfer-Silber-Legierung eine kristalline Phase mit einer B2-Kristallstruktur enthält und

wobei die Palladium-Kupfer-Silber-Legierung 0 Vol% bis 10 Vol% Ausscheidungen von Silber, Palladium und binären Silber-Palladium-Verbindungen aufweist.

Die Summe der Elemente Ruthenium, Rhodium und Rhenium darf in der Palladium-Kupfer-Silber-Legierung zusammen einen Gewichtsanteil von 6 Gew% nicht überschreiten.

Die Anteile an Palladium, Kupfer und Silber sowie die optionalen Anteile von Ruthenium, Rhodium und/oder Rhenium und/oder den Verunreinigungen addieren sich zu 100 Gew%.

Es kann in der Palladium-Kupfer-Silber-Legierung auch keines der Elemente ausgewählt aus der Liste Ruthenium, Rhodium und Rhenium enthalten sein. Die Palladium-Kupfer-Silber-Legierung besteht dann aus den angegebenen Anteilen des Palladiums, des Kupfers, des Silbers und die bis zu 1 Gew% Verunreinigungen.

Mit der Angabe des Anteils der Ausscheidungen in Vol% ist gemeint, dass die Summe der Ausscheidungen von Silber und der Ausscheidungen von Palladium und der Ausscheidungen von binären Silber-Palladium-Verbindungen bei maximal dem angegebenen Volumenanteil von 10 Vol% liegt. Es können in der Palladium-Kupfer-Silber-Legierung erfindungsgemäß also auch gar keine Ausscheidungen von Silber, Palladium und binären Silber-Palladium-Verbindungen enthalten sein. Es wird lediglich ein Anteil von mehr als 10 Vol% dieser Ausscheidungen in Summe ausgeschlossen. Die Ausscheidungen können aus Silber oder Palladium oder aus binären Silber-Palladium-Verbindungen bestehen, die Summe aller dieser Ausscheidungen (Silber, Palladium und binäre Silber-Palladium-Verbindungen) darf jedoch ein Anteil von 10 Vol% nicht überschreiten. In dem Silber, dem Palladium und den binären Silber-Palladium-Verbindungen der Ausscheidungen dürfen dabei nicht mehr als 5 Gew% Kupfer enthalten sein und nicht mehr als 1 Gew% andere Metalle enthalten sein, bevorzugt nicht mehr als 2 Gew% Kupfer enthalten sein. Der Anteil von Silber, Palladium oder binären Silber-Palladium-Verbindungen in der Palladium-Kupfer-Silber-Legierung lässt sich experimentell mit Hilfe eines Rasterelektronenmikroskops (REM) im Phasenkontrast (Messung der Sekundärelektronen) durch eine quantitative Analyse der Flächenanteile eines REM-Bilds eines hinreichend polierten Querschliffs ermitteln. Derartige Verfahren sind dem Fachmann bekannt. Ebenso kann der Anteil mittels EDX-Mapping bestimmt werden (auch hier durch eine Auswertung der Flächenanteile des gemessenen Schliffs). Weitere Möglichkeiten zur Messung sind vorhanden und anwendbar.

Es ist erfindungsgemäß bevorzugt, dass höchstens 1 Gew% Rhenium in der Palladium-Kupfer-Silber-Legierung enthalten ist, besonders bevorzugt höchstens 0,8 Gew% Rhenium in der Palladium-Kupfer-Silber-Legierung enthalten ist.

Dass die Palladium-Kupfer-Silber-Legierung eine kristalline Phase mit einer B2-Kristallstruktur enthält, bedeutet, dass die kristalline Phase mit der B2-Kristallstruktur in der Palladium-Kupfer-Silber-Legierung mit Röntgendiffraktometrie oder mit Elektronenbeugungsbildern zumindest lokal nachweisbar sein muss. Zum Nachweis dienen dabei insbesondere Elektronenbeugungsbilder der Palladium-Kupfer-Silber-Legierung, die die für die B2-Kristallstruktur typischen Reflexe und Beugungsmuster zeigen, die sich von Elektronenbeugungsbildern anderer in der Palladium-Kupfer-Silber-Legierung auftretenden Kristallstrukturen eindeutig unterscheiden lassen. Bei größeren Anteilen der B2-Kristallstruktur (mehr als 1 Vol%) kann die B2-Kristallstruktur auch mittels XRD durch Röntgendiffraktometrie von geeignet präparierten Oberflächen und Pulvern der Palladium-Kupfer-Silber-Legierung nachgewiesen werden. Andere Methoden zum Nachweis der B2-Kristallstruktur in der Palladium-Kupfer-Silber-Legierung sind vorstellbar.

Unter einer Verunreinigung werden chemische Elemente verstanden die in den Metallen der Legierung als übliche Verunreinigungen vorkommen und darstellungsbedingt nicht oder nur durch hohen Aufwand entfernt werden können. Übliche Verunreinigungen können je nach Hersteller und Gewinnung unterschiedlich sein.

Die Bezeichnung B2 bezeichnet eine Raumgruppe nach der Strukturbericht-Symbolik. Die B2-Kristallstruktur oder kurz B2-Struktur ist eine intermetallische Struktur vom Typ CsCl und ist eine kubisch raumzentrierte (bcc - "body centred cubic") Gitterstruktur. Die B2-Kristallstruktur hat eine Raumgruppe *Pm3m* in Hermann-Mauguin-Symbolik. Im binären System Pd-Cu wird diese kristalline Phase auch als β'-Phase bezeichnet. Eine Atomsorte (z.B. Pd) sitzt auf den Ecken (8x 1/8 Atom pro Einheitszelle) und (zumindest) eine andere Atomsorte (z.B. Kupfer und Silber) im Zentrum (1x1 Atom pro Einheitszelle) wodurch sich ein Atomverhältnis von 1:1 ergibt. Von der exakten Mischung kann es leichte Abweichungen davon geben. Eine solche B2-Kristallstruktur tritt bei CsCl auf, aber auch bei NiAl oder eben bei geordnetem binärem PdCu. Die B2-Kristallstruktur kann durch geeignete Mikroskopische Untersuchungen oder TEM-Untersuchungen an für TEM Untersuchungen entsprechend präparierten Proben (z.B. mittels FIB - Focused Ion Beam (fokussierter Ionenstrahl)) oder auch zumindest grob durch quantitative Röntgenbeugungs-Untersuchungen (XRD-Untersuchungen) an Volumenkörpern der Palladium-Kupfer-Silber-Legierung oder auch an Pulvern der Palladium-Kupfer-Silber-Legierung bestimmt werden. Derartige Verfahren sind dem Fachmann bekannt. Für die XRD Messung wurde ein Bragg-Brentano Diffraktometer verwendet, wobei ein Messbereich (2Theta) von 10 - 115 in 0,050 Schrittweite mit 96 s/Schritt Messzeit aufgenommen wurde und eine Kupfer Röntgenquelle mit 40 kV und 40 mA als Röntgenquelle verwendet wurde. Die kristalline Phase mit der B2-Kristallstruktur tritt überraschend auch mit höheren Silbergehalten auf, als es aufgrund der bekannten Untersuchungen zu erwarten gewesen wäre. Gleichzeitig haben Palladium-Kupfer-Silber-Legierungen mit dieser kristallinen Phase mit der B2-Kristallstruktur auch für die erfindungsgemäßen Anwendungen besonders vorteilhafte physikalische Eigenschaften.

Die Palladium-Kupfer-Silber-Legierung ist vorzugsweise zur Herstellung von Prüfnadeln und/oder Schleifkontakten geeignet.

Es kann auch vorgesehen sein, dass die Palladium-Kupfer-Silber-Legierung

     (a) 41 bis 56 Gew% Palladium,
     (b) 26 bis 42 Gew% Kupfer und
     (c) 7 bis 19 Gew% Silber enthält,

bevorzugt

     (a) 41 bis 56 Gew% Palladium,
     (b) 26 bis 42 Gew% Kupfer und
     (c) 8 bis 18 Gew% Silber enthält,

mehr bevorzugt

     (a) 41 bis 56 Gew% Palladium,
     (b) 26 bis 42 Gew% Kupfer und
     (c) 9 bis 18 Gew% Silber enthält,

noch mehr bevorzugt

     (a) 41 bis 56 Gew% Palladium,
     (b) 26 bis 42 Gew% Kupfer und
     (c) 10 bis 18 Gew% Silber enthält.

Bei höheren minimalen Silber-Anteilen wurde überraschend ein größerer Anteil der B2-Kristallstruktur und keine oder überraschend geringe Anteile (bis zu 10 Vol%) von Ausscheidungen von Silber, Palladium und binären Silber-Palladium-Verbindungen gefunden, als es aufgrund der aus dem Stand der Technik bekannten Untersuchungen zu erwarten gewesen wäre. Zudem ergeben sich günstige physikalische Eigenschaftskombinationen.

Es kann des Weiteren vorgesehen sein, dass die Palladium-Kupfer-Silber-Legierung

     (a) 41 bis 56 Gew% Palladium,
     (b) 26 bis 42 Gew% Kupfer und
     (c) 6 bis 18 Gew% Silber enthält,

bevorzugt

(a) 41 bis 56 Gew% Palladium,
(b) 26 bis 42 Gew% Kupfer und
(c) 6 bis 16 Gew% Silber enthält,

mehr bevorzugt

(a) 41 bis 56 Gew% Palladium,
(b) 26 bis 42 Gew% Kupfer und
(c) 6 bis 14 Gew% Silber enthält.

Es kann vorgesehen sein, dass die Palladium-Kupfer-Silber-Legierung

(a) 41 bis 56 Gew% Palladium,
(b) 26 bis 42 Gew% Kupfer und
(c) 7 bis 18 Gew% Silber enthält,

bevorzugt

(a) 41 bis 56 Gew% Palladium,
(b) 26 bis 42 Gew% Kupfer und
(c) 8 bis 17 Gew% Silber enthält,

mehr bevorzugt

(a) 41 bis 56 Gew% Palladium,
(b) 26 bis 42 Gew% Kupfer und
(c) 9 bis 16 Gew% Silber enthält,

noch mehr bevorzugt

(a) 41 bis 56 Gew% Palladium,
(b) 26 bis 42 Gew% Kupfer und
(c) 10 bis 15 Gew% Silber enthält.

Erfindungsgemäß kann ferner vorgesehen sein, dass die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist. Ein Gewichtsverhältnis von Palladium zu Kupfer von mindestens 1,05 und maximal 1,6 bedeutet, dass das Palladium mit einem Gewicht von mindestens 105% und maximal 160% des Gewichts des in der Palladium-Kupfer-Silber-Legierung enthaltenen Kupfers in der Palladium-Kupfer-Silber-Legierung enthalten ist.

Dementsprechend bedeutet ein Gewichtsverhältnis von Palladium zu Silber von mindestens 3 und maximal 6, dass das Palladium mit einem Gewicht von mindestens dem dreifachen und maximal dem sechsfachen des Gewichts des in der Palladium-Kupfer-Silber-Legierung enthaltenen Silbers in der Palladium-Kupfer-Silber-Legierung enthalten ist.

Es kann vorgesehen sein, dass die Palladium-Kupfer-Silber-Legierung ein Gewichtsverhältnis von Palladium zu Kupfer von mindestens 1,2 und maximal 1,55 aufweist, bevorzugt ein Gewichtsverhältnis von Palladium zu Kupfer von mindestens 1,3 und maximal 1,5 aufweist, besonders bevorzugt ein Gewichtsverhältnis von Palladium zu Kupfer von mindestens 1,35 und maximal 1,45 aufweist, ganz besonders bevorzugt ein Gewichtsverhältnis von Palladium zu Kupfer von 1,41 aufweist.

Diese Gewichtsverhältnisse liefern Palladium-Kupfer-Silber-Legierungen mit besonders hoher elektrischer Leitfähigkeit.

Es kann vorgesehen sein, dass die Palladium-Kupfer-Silber-Legierung ein Gewichtsverhältnis von Palladium zu Silber von mindestens 3,5 und maximal 5,5 aufweist, bevorzugt ein Gewichtsverhältnis von Palladium zu Silber von mindestens 4 und maximal 5,5 aufweist, besonders bevorzugt ein Gewichtsverhältnis von Palladium zu Silber von mindestens 4,6 und maximal 5,2 aufweist, ganz besonders bevorzugt ein Gewichtsverhältnis von Palladium zu Silber von 4,9 aufweist.

Auch diese Gewichtsverhältnisse liefern Palladium-Kupfer-Silber-Legierungen mit besonders hoher elektrischer Leitfähigkeit.

Es kann vorgesehen sein, dass die Palladium-Kupfer-Silber-Legierung ein Gewichtsverhältnis von Palladium zu Kupfer von mindestens 1,2 und maximal 1,55 aufweist und ein Gewichtsverhältnis von Palladium zu Silber von mindestens 3,5 und maximal 5,5 aufweist, bevorzugt ein Gewichtsverhältnis von Palladium zu Kupfer von mindestens 1,3 und maximal 1,5 aufweist und ein Gewichtsverhältnis von Palladium zu Silber von mindestens 4 und maximal 5,5 aufweist, besonders bevorzugt ein Gewichtsverhältnis von Palladium zu Kupfer von mindestens 1,35 und maximal 1,45 aufweist und ein Gewichtsverhältnis von Palladium zu Silber von mindestens 4,6 und maximal 5,2 aufweist, ganz besonders bevorzugt ein Gewichtsverhältnis von Palladium zu Kupfer von 1,41 aufweist und ein Gewichtsverhältnis von Palladium zu Silber von 4,9 aufweist.

Auch diese Gewichtsverhältnisse liefern Palladium-Kupfer-Silber-Legierungen mit besonders hoher elektrischer Leitfähigkeit.

Des Weiteren kann vorgesehen sein, dass die Palladium-Kupfer-Silber-Legierung zumindest 0,1 Gew% wenigstens eines Elements, das aus der Gruppe ausgewählt ist, die aus Ruthenium, Rhodium und Rhenium besteht, enthält.

Es kann vorgesehen sein, dass die Palladium-Kupfer-Silber-Legierung zumindest 1 Gew% wenigstens eines Elements, das aus der Gruppe ausgewählt ist, die aus Ruthenium, Rhodium und Rhenium besteht, enthält.

Es kann vorgesehen sein, dass die Palladium-Kupfer-Silber-Legierung zumindest 1,5 Gew% wenigstens eines Elements, das aus der Gruppe ausgewählt ist, die aus Ruthenium, Rhodium und Rhenium besteht, enthält.

Es kann auch vorgesehen sein, dass die Palladium-Kupfer-Silber-Legierung höchstens 5 Gew% wenigstens eines Elements, das aus der Gruppe ausgewählt ist, die aus Ruthenium, Rhodium und Rhenium besteht, enthält, bevorzugt höchstens 4 Gew% wenigstens eines Elements, das aus der Gruppe ausgewählt ist, die aus Ruthenium, Rhodium und Rhenium besteht, enthält, besonders bevorzugt höchstens 3 Gew% wenigstens eines Elements, das aus der Gruppe ausgewählt ist, die aus Ruthenium, Rhodium und Rhenium besteht, enthält.

Die Summe der Elemente Ruthenium, Rhodium und Rhenium darf zusammen einen Gewichtsanteil in der Palladium-Kupfer-Silber-Legierung von 5 Gew% nicht überschreiten, bevorzugt einen Gewichtsanteil in der Palladium-Kupfer-Silber-Legierung von 4 Gew% nicht überschreiten, besonders bevorzugt einen Gewichtsanteil in der Palladium-Kupfer-Silber-Legierung von 3 Gew% nicht überschreiten.

Es kann vorgesehen sein, dass die Palladium-Kupfer-Silber-Legierung mindestens 0,1 Gew% und höchstens 5 Gew% wenigstens eines Elements, das aus der Gruppe ausgewählt ist, die aus Ruthenium, Rhodium und Rhenium besteht, enthält, bevorzugt mindestens 1 Gew% und höchstens 4 Gew% wenigstens eines Elements, das aus der Gruppe ausgewählt ist, die aus Ruthenium, Rhodium und Rhenium besteht, enthält, besonders bevorzugt mindestens 1 Gew% und höchstens 3 Gew% wenigstens eines Elements, das aus der Gruppe ausgewählt ist, die aus Ruthenium, Rhodium und Rhenium besteht, enthält.

Die Summe der Elemente Ruthenium, Rhodium und Rhenium darf zusammen einen Gewichtsanteil in der Palladium-Kupfer-Silber-Legierung von 5 Gew% nicht überschreiten, bevorzugt einen Gewichtsanteil in der Palladium-Kupfer-Silber-Legierung von 4 Gew% nicht überschreiten, besonders bevorzugt einen Gewichtsanteil in der Palladium-Kupfer-Silber-Legierung von 3 Gew% nicht überschreiten.

Dass die Legierung mehr als 0,1 Gew% und höchstens 5 Gew% wenigstens eines Elements, das aus der Gruppe ausgewählt ist, die aus Ruthenium, Rhodium und Rhenium besteht, enthält, bedeutet, dass die Summe der Gewichtsanteile von dem wenigstens einen Element der Gruppe zusammen mehr als 0,1 Gew% und bis maximal 5 Gew% des Gewichts der gesamten Legierung ausmachen. Allgemein bedeutet, dass die Legierung mehr oder weniger oder genau X Gew% Rhenium, Ruthenium und/oder Rhodium beinhaltet, dass die Summe der Gewichtsanteile von Rhenium, Ruthenium und/oder Rhodium zusammen den entsprechenden prozentualen Anteil X Gew% des Gewichts der gesamten Legierung ausmachen.

Des Weiteren kann vorgesehen sein, dass die Palladium-Kupfer-Silber-Legierung bis zu 1 Gew% Rhenium enthält, wobei bevorzugt die Palladium-Kupfer-Silber-Legierung weniger als 0,1 Gew% Rhodium enthält, besonders bevorzugt die Palladium-Kupfer-Silber-Legierung mehr als 1 Gew% und maximal 2 Gew% Ruthenium und zwischen 0,1 Gew% und 1 Gew% Rhenium enthält, ganz besonders bevorzugt mindestens 1,1 Gew% und maximal 1,5 Gew% Ruthenium und zwischen 0,2 Gew% und 0,8 Gew% Rhenium enthält, speziell bevorzugt 1,1 Gew% Ruthenium und 0,4 Gew% Rhenium enthält.

Die Palladium-Kupfer-Silber-Legierung enthält dabei vorzugsweise mehr als 1 Gew% und maximal 6 Gew% Ruthenium.

Diese Palladium-Kupfer-Silber-Legierung(en) haben experimentell überraschend eine besonders hohe elektrische Leitfähigkeit von zumindest 25% IACS (14,5 * $10^6$ S/m) bei gleichzeitig hoher Härte von 365 HV1 gezeigt. Vermutlich sind hierfür Ruthenium-Rhenium-Ausscheidungen an den Korngrenzen der Palladium-Kupfer-Silber-Legierung verantwortlich. Ferner kann vorgesehen sein, dass die Palladium-Kupfer-Silber-Legierung Ausscheidungen von Ruthenium, Rhodium, Rhenium oder einer Mischung aus zweien der Elemente ausgewählt aus Ruthenium, Rhodium und Rhenium oder einer Mischung aus Ruthenium, Rhodium und Rhenium enthält, wobei bevorzugt zumindest 90 Vol% der Ausscheidungen an Korngrenzen der Palladium-Kupfer-Silber-Legierung angeordnet sind, besonders bevorzugt zumindest 99 Vol% der Ausscheidungen an Korngrenzen der Palladium-Kupfer-Silber-Legierung angeordnet sind. Hierdurch werden die die mechanischen Eigenschaften, wie beispielsweise die Bruchfestigkeit und der Verformungswiderstand erhöht. Dadurch ist die Palladium-Kupfer-Silber-Legierung besser als Prüfnadel einsetzbar.

Es kann auch vorgesehen sein, dass die Verunreinigungen in der Summe einen Anteil von maximal 0,9 Gew% in der Palladium-Kupfer-Silber-Legierung haben, bevorzugt einen Anteil von maximal 0,1 Gew% in der Palladium-Kupfer-Silber-Legierung haben.

Hierdurch wird sichergestellt, dass die physikalischen Eigenschaften der Palladium-Kupfer-Silber-Legierung nicht oder möglichst wenig von den Verunreinigungen beeinflusst werden. Unter einer Mischung von mehreren Elementen wird vorzugsweise eine Mischung verstanden, bei der zumindest 0,1 Gew% aller dieser Elemente in der Palladium-Kupfer-Silber-Legierung enthalten sind.

Auch kann vorgesehen sein, dass die Palladium-Kupfer-Silber-Legierung bis zu 6 Gew% zumindest eines Elements, das aus der Gruppe ausgewählt ist, die aus Ruthenium und Rhodium besteht, enthält, bevorzugt von 0,1 Gew% bis zu 6 Gew% zumindest eines Elements, das aus der Gruppe ausgewählt ist, die aus Ruthenium und Rhodium besteht, enthält, besonders bevorzugt von 1 Gew% bis zu 6 Gew% zumindest eines Elements, das aus der Gruppe ausgewählt ist, die aus Ruthenium und Rhodium besteht, enthält.

Es kann vorgesehen sein, dass die Palladium-Kupfer-Silber-Legierung zumindest 1 Vol% der kristallinen Phase mit einer B2-Kristallstruktur enthält, bevorzugt zumindest 2 Vol% der kristallinen Phase mit einer B2-Kristallstruktur enthält, besonders bevorzugt zumindest zu 5 Vol% der kristallinen Phase mit einer B2-Kristallstruktur enthält.

Des Weiteren kann vorgesehen sein, dass die kristalline Phase mit der B2-Kristallstruktur einen Silbergehalt von zumindest 6 Gew% aufweist.

Die Ausbildung der kristallinen Phase mit der B2-Kristallstruktur bei diesen Silbergehalten ist überraschend, insbesondere bei Temperaturbehandlungen mit Temperaturen von maximal 500 °C oder sogar weniger als 400 °C.

Es kann vorgesehen sein, dass die kristalline Phase mit der B2-Kristallstruktur einen Silbergehalt von zumindest 7 Gew% aufweist, bevorzugt einen Silbergehalt von zumindest 8 Gew% aufweist, besonders bevorzugt einen Silbergehalt von zumindest 9 Gew% aufweist, ganz besonders bevorzugt einen Silbergehalt von zumindest 10 Gew% aufweist.

Es kann vorgesehen sein, dass die kristalline Phase mit der B2-Kristallstruktur mindestens 40 Gew% und maximal 58 Gew% Palladium und mindestens 25 Gew% und maximal 42 Gew% Kupfer aufweist, bevorzugt mindestens 41 Gew% und maximal 56 Gew% Palladium und mindestens 26 Gew% und maximal 42 Gew% Kupfer aufweist.

Es kann vorgesehen sein, dass die kristalline Phase mit der B2-Kristallstruktur durch eine Temperaturbehandlung entsteht, bevorzugt durch Tempern bei einer Temperatur zwischen 250 °C und 500 °C für einen Zeitraum von wenigstens 1 Minute entsteht, wobei besonders bevorzugt im Anschluss an das Tempern die Palladium-Kupfer-Silber-Legierung keiner weiteren Temperaturbehandlung mit einer Temperatur von mehr als 500 °C unterzogen wird.

Es kann vorgesehen sein, dass die kristalline Phase mit der B2-Kristallstruktur durch ein Glühen bei einer Temperatur zwischen 300 °C und 450 °C für einen Zeitraum von wenigstens 2 Minuten entsteht, bevorzugt die kristalline Phase mit der B2-Kristallstruktur durch ein Glühen bei einer Temperatur zwischen 300 °C und 450 °C für einen Zeitraum von wenigstens 2 Minuten entsteht, besonders bevorzugt die kristalline Phase mit der B2-Kristallstruktur durch ein Glühen bei einer Temperatur zwischen 300 °C und 450 °C für einen Zeitraum von wenigstens 2 Minuten entsteht, ganz besonders bevorzugt die kristalline Phase mit der B2-Kristallstruktur durch ein Glühen bei einer Temperatur zwischen 350 °C und 400 °C für einen Zeitraum von wenigstens 3 Minuten entsteht.

Die kristalline Phase mit der B2-Kristallstruktur wird bevorzugt nicht durch eine Temperaturbehandlung bei 375 °C bis 385 °C für 1 h bis 2 h erzeugt, besonders bevorzugt nicht durch eine Temperaturbehandlung bei 380 °C für 1,5 h erzeugt.

Es kann auch vorgesehen sein, dass die kristalline Phase mit der B2-Kristallstruktur durch ein Abschrecken der Palladium-Kupfer-Silber-Legierung nach einer Temperaturbehandlung, insbesondere nach einem Tempern, oder nach einem Glühen erhalten wird.

Das Abschrecken erfolgt dabei vorzugsweise über einen Temperaturbereich von wenigstens 250 °C mit einer Abkühlrate von mindestens 10 °C pro Sekunde.

Ferner kann vorgesehen sein, dass die Palladium-Kupfer-Silber-Legierung durch mehrfache Wärmebehandlungen und mehrfaches Walzen geformt und gehärtet ist, wobei vorzugsweise die Wärmebehandlungen bei einer Temperatur zwischen 700 °C und 950 °C erfolgt und nach der Wärmebehandlung ein Abschrecken erfolgt, wobei während der Wärmebehandlung kein Schmelzen der Palladium-Kupfer-Silber-Legierung erfolgt.

Das Abschrecken erfolgt dabei vorzugsweise über einen Temperaturbereich von wenigstens 400 °C mit einer Abkühlrate von mindestens 10 °C pro Sekunde.

Des Weiteren kann vorgesehen sein, dass die Palladium-Kupfer-Silber-Legierung schmelzmetallurgisch hergestellt ist und anschließend durch Walzen und Tempern gehärtet ist, wobei vorzugsweise die Palladium-Kupfer-Silber-Legierung eine Härte von mindestens 380 HV0,05 aufweist.

Hierdurch kann die Härte der Palladium-Kupfer-Silber-Legierung verbessert werden.

Es kann vorgesehen sein, dass die Palladium-Kupfer-Silber-Legierung eine Härte von mindestens 380 HV0,05 aufweist.

Es kann vorgesehen sein, dass die Palladium-Kupfer-Silber-Legierung eine elektrische Leitfähigkeit von mindestens 22% IACS (12,8 * $10^6$ S/m) aufweist, bevorzugt eine elektrische Leitfähigkeit von mindestens 25% IACS (14,5 * $10^6$ S/m) aufweist, besonders bevorzugt eine elektrische Leitfähigkeit von mindestens 26% IACS (15,1 * $10^6$ S/m) aufweist.

Es kann vorgesehen sein, dass die Palladium-Kupfer-Silber-Legierung eine Zugfestigkeit von mindestens 1300 MPa aufweist.

Palladium-Kupfer-Silber-Legierungen mit diesen physikalischen Eigenschaften sind mit den erfindungsgemäßen Zugaben von Ruthenium und Rhodium möglich und eignen sich besonders zur Herstellung von Prüfnadeln.

Bevorzugt kann auch vorgesehen sein, dass die Palladium-Kupfer-Silber-Legierung eine mittlere Korngröße von maximal 2 $\mu$m aufweist.

Es kann bevorzugt vorgesehen sein, dass die Palladium-Kupfer-Silber-Legierung eine mittlere Korngröße von maximal 1,5 $\mu$m aufweist, bevorzugt eine mittlere Korngröße von maximal 1 $\mu$m aufweist.

Es kann besonders bevorzugt vorgesehen sein, dass die Palladium-Kupfer-Silber-Legierung eine mittlere Korngröße von mindestens 0,01 $\mu$m aufweist, bevorzugt eine mittlere Korngröße von mindestens 0,05 $\mu$m aufweist, besonders bevorzugt eine mittlere Korngröße von mindestens 0,1 $\mu$m aufweist.

Die Bestimmung der mittleren Korngröße erfolgt entsprechend oder analog nach DIN EN ISO 643:2019, korrigierte Fassung 2020-03 / Deutsche Fassung ISO 643:2020 vom Juni 2020, wobei der Mittelwert von Linienschnittsegmenten eines Querschliffs bestimmt wird. Die Probenvorbereitung erfolgt wie in der Norm beschrieben, obwohl es sich vorliegend bei der Palladium-Kupfer-Silber-Legierung nicht um einen Stahl handelt. Das Ätzverfahren kann auf die chemische Beständigkeit der Palladium-Kupfer-Silber-Legierung angepasst werden, so dass die Korngrenzen der Körner der Palladium-Kupfer-Silber-Legierung möglichst gut sichtbar sind. Sofern die Palladium-Kupfer-Silber-Legierung bei der Herstellung gewalzt wurde, wird der zu untersuchende Querschliff parallel zu der von den Walzen ausgeübten Kraft geschnitten und geschliffen und poliert.

Es kann vorgesehen sein, dass die Palladium-Kupfer-Silber-Legierung eine mittlere Korngröße von mindestens 0,01 $\mu$m und von maximal 2 $\mu$m aufweist, bevorzugt eine mittlere Korngröße von mindestens 0,05 $\mu$m und maximal 1,5 $\mu$m, besonders bevorzugt eine mittlere Korngröße von mindestens 0,1 $\mu$m und maximal 1 $\mu$m.

Es kann vorgesehen sein, dass die Palladium-Kupfer-Silber-Legierung eine mittlere Korngröße von mindestens 0,01 $\mu$m und von maximal 2 $\mu$m aufweist, bevorzugt eine mittlere Korngröße von mindestens 0,05 $\mu$m und maximal 2 $\mu$m, besonders bevorzugt eine mittlere Korngröße von mindestens 0,1 $\mu$m und maximal 2 $\mu$m.

Es kann vorgesehen sein, dass die Palladium-Kupfer-Silber-Legierung eine mittlere Korngröße von mindestens 0,1 $\mu$m und von maximal 2 $\mu$m aufweist, bevorzugt eine mittlere Korngröße von mindestens 0,1 $\mu$m und maximal 1,5 $\mu$m, besonders bevorzugt eine mittlere Korngröße von mindestens 0,1 $\mu$m und maximal 1 $\mu$m.

Gemäß einer bevorzugten Weiterbildung kann vorgesehen sein, dass die Palladium-Kupfer-Silber-Legierung weniger als 5 Vol% Ausscheidungen von Silber, Palladium und binären Silber-Palladium-Verbindungen aufweist, bevorzugt weniger als weniger als 2 Vol% Ausscheidungen von Silber, Palladium und binären Silber-Palladium-Verbindungen aufweist, besonders bevorzugt weniger als weniger als 1 Vol% Ausscheidungen von Silber, Palladium und binären Silber-Palladium-Verbindungen aufweist, ganz besonders bevorzugt keine Ausscheidungen von Silber, Palladium und binären Silber-Palladium-Verbindungen aufweist. Mit der Angabe des Anteils in Vol% ist gemeint, dass die Summe der Ausscheidungen von Silber und der Ausscheidungen von Palladium und der Ausscheidungen von binären Silber-Palladium-Verbindungen unterhalb des angegebenen Volumenanteils liegt.

Hierdurch wird eine hohe elektrische Leitfähigkeit bei gleichzeitig hoher Bruchfestigkeit der Palladium-Kupfer-Silber-Legierung erreicht.

Es kann auch vorgesehen sein, dass die Palladium-Kupfer-Silber-Legierung weniger als 5 Vol% Silber-Ausscheidungen aufweist, bevorzugt weniger als weniger als 2 Vol% Silber-Ausscheidungen aufweist, besonders bevorzugt weniger als weniger als 1 Vol% Silber-Ausscheidungen aufweist.

Unter einer Silber-Ausscheidung ist vorliegend eine Ausscheidung zu verstehen, die zumindest zu 95 Gew% aus Silber besteht, bevorzugt zu zumindest 99 Gew% aus Silber besteht.

Es kann auch vorgesehen sein, dass die Palladium-Kupfer-Silber-Legierung weniger als 5 Vol% Palladium-Ausscheidungen aufweist, bevorzugt weniger als weniger als 2 Vol% Palladium-Ausscheidungen aufweist, besonders bevorzugt weniger als weniger als 1 Vol% Palladium-Ausscheidungen aufweist.

Unter einer Palladium-Ausscheidung ist vorliegend eine Ausscheidung zu verstehen, die zumindest zu 95 Gew% aus Palladium besteht, bevorzugt zu zumindest 99 Gew% aus Palladium besteht.

Es kann auch vorgesehen sein, dass die Palladium-Kupfer-Silber-Legierung weniger als 5 Vol% Silber-Palladium-Ausscheidungen aufweist, bevorzugt weniger als weniger als 2 Vol% Silber-Palladium-Ausscheidungen aufweist, besonders bevorzugt weniger als weniger als 1 Vol% Silber-Palladium-Ausscheidungen aufweist.

Unter einer Silber-Palladium-Ausscheidung ist vorliegend eine Ausscheidung zu verstehen, die zumindest zu 95 Gew% aus Silber und Palladium besteht, bevorzugt zu zumindest 99 Gew% aus Silber und Palladium besteht.

Die der vorliegenden Erfindung zugrundeliegenden Aufgaben werden auch gelöst durch einen Formkörper bestehend aus einer zuvor beschriebenen Palladium-Kupfer-Silber-Legierung, wobei bevorzugt der Formkörper die Form eines allgemeinen Zylinders mit beliebiger Grundfläche oder eines spulenartig aufgewickelten allgemeinen Zylinders mit beliebiger Grundfläche aufweist, wobei besonders bevorzugt die Höhe des allgemeinen Zylinders größer ist als alle Abmessungen der Grundfläche des allgemeinen Zylinders, wobei ganz besonders bevorzugt ein Minimalquerschnitt der Grundfläche maximal 500 $\mu$m beträgt und ein Maximalquerschnitt der Grundfläche maximal 10 mm beträgt.

Der Formkörper kann an seinen Oberflächen zumindest bereichsweise beschichtet sein.

Der Formkörper hat (gegebenenfalls bis auf wenige durch die Herstellung die Form eines allgemeinen Zylinders) also eine zylindrische Geometrie. Die allgemeine zylindrische Form ist zur Weiterverarbeitung als Draht-Stück oder Band-Stück besonders gut geeignet. Geometrisch ist unter einer Form eines allgemeinen Zylinders ein Zylinder mit einer beliebigen Grundfläche zu verstehen, also nicht nur ein Zylinder mit einer kreisförmigen Grundfläche. Die radiale Mantelfläche des Formkörpers kann also durch den Zylindermantel eines Zylinders mit beliebiger Grundfläche realisiert sein, insbesondere mit unterschiedlich geformten Grundflächen realisiert sein, das heißt auch mit nicht kreisförmigen und mit nicht runden Grundflächen, beispielsweise mit rechteckiger oder ovaler Grundfläche. Erfindungsgemäß wird jedoch eine zylindrische Geometrie mit rotationssymmetrischer und insbesondere kreisrunder Grundfläche oder mit breiter rechteckiger Grundfläche für den Formkörper bevorzugt, da ein Draht mit rundem oder kreisrundem Querschnitt oder ein flaches Band mit rechteckigem Querschnitt am einfachsten weiterzuverarbeiten ist. Bei der Ausbildung als Band wird bevorzugt, dass die Grundfläche des allgemeinen Zylinders eine Breite aufweist, die zumindest 5 mal größer ist als die Dicke der Grundfläche des allgemeinen Zylinders, besonders bevorzugt, dass die Grundfläche des allgemeinen Zylinders eine Breite aufweist, die zumindest 20 mal größer ist als die Dicke der Grundfläche des allgemeinen Zylinders, ganz besonders bevorzugt, dass die Grundfläche des allgemeinen Zylinders eine Breite aufweist, die zumindest 50 mal größer ist als die Dicke der Grundfläche des allgemeinen Zylinders.

Der Minimalquerschnitt ist definiert als der Abstand zweier paralleler Tangenten einer Oberfläche (hier des Rands der Grundfläche des allgemeinen Zylinders), wobei die Tangenten mit dem kleinsten möglichen Abstand gewählt werden. Der Maximalquerschnitt ist definiert als der Abstand zweier paralleler Tangenten einer Oberfläche (hier des Rands der Grundfläche des allgemeinen Zylinders), wobei die Tangenten mit dem größten möglichen Abstand gewählt werden. Diese Definition entspricht bei runden Grundflächen dem Messprinzip eines Messschiebers, weicht jedoch bei Einschnürungen davon ab.

Drähte, Bänder und Prüfnadeln aus solchen Palladium-Kupfer-Silber-Legierungen sind aufgrund ihrer hohen Härte, Elastizität und elektrischen Leitfähigkeit besonders gut für elektrische Kontaktmessungen geeignet.

Es kann vorgesehen sein, dass der Formkörper ein Draht oder ein Band ist, wobei bevorzugt der Draht oder das Band als Spule aufwickelt ist. Der Formkörper ist dann genaugenommen nicht mehr exakt zylindrisch, sondern ein aus einem Zylinder gewonnener Körper. Im Sinne der vorliegenden Erfindung sollen aber derartige Geometrien auch bei solchen Abweichungen noch als Zylinder verstanden werden. Die geometrischen Angaben sind also nicht als mathematisch exakt zu verstehen.

Die der vorliegenden Erfindung zugrundeliegenden Aufgaben werden auch gelöst durch eine Prüfnadel oder einen Schleifkontaktdraht bestehend aus einer zuvor beschriebenen Palladium-Kupfer-Silber-Legierung, wobei bevorzugt die Prüfnadel oder der Schleifkontaktdraht zumindest abschnittsweise die Form eines allgemeinen Zylinders mit beliebiger Grundfläche oder eines gebogenen allgemeinen Zylinders mit beliebiger Grundfläche aufweist, wobei besonders bevorzugt ein Minimalquerschnitt der Grundfläche maximal 500 $\mu$m beträgt und ein Maximalquerschnitt der Grundfläche maximal 10 mm beträgt und/oder die Prüfnadel an einem Ende an einer Karte befestigt und elektrisch kontaktiert ist und das andere Ende frei schwebend gelagert ist oder der Schleifkontaktdraht an einem Ende an einem elektrischen Kontakt befestigt und elektrisch kontaktiert ist und das andere Ende frei schwebend gelagert ist.

Die der vorliegenden Erfindung zugrundeliegenden Aufgaben werden auch gelöst durch die Verwendung einer solchen Palladium-Kupfer-Silber-Legierung oder eines solchen Formkörpers oder eines Teilstücks eines solchen Formkörpers oder zum Prüfen von elektrischen Kontakten oder zur elektrischen Kontaktierung oder zur Herstellung eines Schleifkontakts.

Für diese Anwendungen sind die erfindungsgemäßen Palladium-Kupfer-Silber-Legierung und die draus gefertigten Formkörper, Drähte, Bänder und Prüfnadeln besonders gut geeignet.

Die der vorliegenden Erfindung zugrundeliegenden Aufgaben werden auch gelöst durch ein Verfahren zur Herstellung einer Palladium-Kupfer-Silber-Legierung gekennzeichnet durch die chronologischen Schritte:

    A) Optional Vorlegieren von Palladium mit wenigstens einem der Elemente ausgewählt aus der Liste Ruthenium, Rhodium und Rhenium mit einem molaren Verhältnis von Palladium zu dem wenigstens einen Element ausgewählt aus der Liste Ruthenium, Rhodium und Rhenium von mindestens 3:1 durch Schmelzen zum Herstellen eine Palladium-Vorlegierung;

    B) Legieren von Palladium oder der Palladium-Vorlegierung mit Kupfer und Silber durch Schmelzen und Erstarren in Vakuum und/oder unter einem Schutzgas, wobei mindestens 40 Gew% und maximal 58 Gew% Palladium oder mindestens 40 Gew% und maximal 64 Gew% Palladium-Vorlegierung, mindestens 25 Gew% und maximal 42 Gew% Kupfer und mindestens 6 Gew% und maximal 20 Gew% Silber eingewogen werden;

    C) Mehrfache Bearbeitung durch Glühen bei einer Temperatur von mehr als 750 °C für wenigstens 10 Minuten und anschließendem Abschrecken und anschließendem Walzen;

    D) Walzen zum Erreichen einer Enddicke von maximal 100 $\mu$m;

    E) Abschlussglühen bei einer Temperatur zwischen 250 °C und 600 °C für einen Zeitraum von wenigstens 1 Minute.

Wenn das Schmelzen und Erstarren in Vakuum und unter einem Schutzgas erfolgt, erfolgt vorzugsweise zumindest ein Teil des Erwärmens der Metalle unter Vakuum, während das Schmelzen und Erstarren unter einem Schutzgas erfolgt.

Das Glühen in Schritt C) muss bei einer Temperatur unterhalb der Schmelztemperatur der Palladium-Kupfer-Silber-Legierung erfolgen.

Wenn die Palladium-Vorlegierung eingewogen wird, muss bei der Bestimmung der Einwaage des Palladiums darauf geachtet werden, dass der Palladium-Gehalt in der Palladium-Vorlegierung weniger als 100 Gew% ist. Dementsprechend muss zum Erreichen der gewünschten Einwaage von Palladium dementsprechend ein größerer Gewichts-Anteil der Palladium-Vorlegierung eingewogen werden. Der Anteil von dem wenigstens einen Element ausgewählt aus der Liste Ruthenium, Rhodium und Rhenium ergibt sich dabei automatisch und muss folglich schon beim Herstellen der Palladium-Vorlegierung in Schritt A) eingestellt werden. Es kann vorgesehen sein, dass in Schritt B) ein Gewichtsverhältnis von Palladium zu Kupfer von mindestens 1,05 und maximal 1,6 und ein Gewichtsverhältnis von Palladium zu Silber von mindestens 3 und maximal 6 eingewogen wird.

Ferner kann vorgesehen sein, dass in Schritt B) das Schmelzen durch Induktionsschmelzen oder durch Vakuuminduktionsschmelzen erfolgt.

Des Weiteren kann vorgesehen sein, dass in Schritt B) als Schutzgas ein Edelgas, insbesondere Argon, verwendet wird, vorzugsweise mit einem Partialdruck zwischen 10 mbar und 100 mbar.

Auch kann vorgesehen sein, dass in Schritt B) das Erstarren durch Abgießen in einer Kupferkokille durchgeführt wird, insbesondere in einer ungekühlten Kupferkokille durchgeführt wird, wobei vorzugsweise die Temperatur der Schmelze vor dem Abgießen weniger als 100 °C über der Schmelztemperatur der Palladium-Kupfer-Silber-Legierung liegt.

Des Weiteren kann vorgesehen sein, dass in Schritt C) das Abschrecken in Wasser durchgeführt wird.

Auch kann vorgesehen sein, dass in Schritt C) das Glühen bei einer Temperatur zwischen 850 °C und 950 °C durchgeführt wird, bevorzugt bei einer Temperatur von 900 °C durchgeführt wird. Ferner kann vorgesehen sein, dass in Schritt E) das Abschlussglühen bei einer Temperatur zwischen 300 °C und 450 °C erfolgt, bevorzugt bei einer Temperatur zwischen 360 °C und 400 °C erfolgt.

Es kann vorgesehen sein, dass in Schritt C) das Glühen für einen Zeitraum zwischen 0,5 h und 2 h erfolgt und/oder das Glühen in einer reduzierenden Atmosphäre durchgeführt wird, insbesondere unter Kohlenmonoxid durchgeführt wird.

Es kann auch vorgesehen sein, dass in Schritt C) beim Walzen eine Umformung zwischen 10% und 80% erfolgt, bevorzugt eine Umformung zwischen 40% und 60% erfolgt.

Eine Umformung von X% bedeutet, dass beim Walzen ein Querschnitt der Palladium-Kupfer-Silber-Legierung auf wenigstens X% des Querschnitts reduziert wird.

Es kann vorgesehen sein, dass in Schritt E) das Abschlussglühen für einen Zeitraum mindestens 1 Minute erfolgt, bevorzugt für einen Zeitraum von mindestens 2 Minuten erfolgt, besonders bevorzugt für einen Zeitraum von mindestens 5 Minuten erfolgt.

Das Abschlussglühen in Schritt E) erfolgt bevorzugt nicht durch eine Temperaturbehandlung bei 375 °C bis 385 °C für 1 h bis 2 h, besonders bevorzugt nicht durch eine Temperaturbehandlung bei 380 °C für 1,5 h.

Es kann vorgesehen sein, dass in Schritt A) das Vorlegieren in einer reduzierenden Atmosphäre durchgeführt wird, bevorzugt in einer CO-Atmosphäre durchgeführt wird.

Der Erfindung liegt die überraschende Erkenntnis zugrunde, dass die erfindungsgemäßen Palladium-Kupfer-Silber-Legierungen mit der B2-Kristallstruktur auch bei überraschend hohen Silbergehalten gebildet werden, ohne dass größere Mengen (mehr als 10 Vol%) von Silber, Palladium und binären Silber-Palladium-Verbindungen als Ausscheidungen entstehen. Mit solchen Palladium-Kupfer-Silber-Legierungen kann eine hohe elektrische Leitfähigkeit mit einer hohen Härte kombiniert wird. Gleichzeitig sind die Palladium-Kupfer-Silber-Legierungen unaufwendig in der Herstellung. Die aus den erfindungsgemäßen Legierungen hergestellten Formkörper, Drähte, Bänder, Schleifkontakte und Prüfnadeln haben die entsprechenden vorteilhaften Eigenschaften. Aus dem Stand der Technik und aus den Untersuchungen zum ternären Cu-Ag-Pd-Phasendiagramm konnte nicht erwartet werden, eine Legierung mit der B2-Kristallstruktur auch bei hohen Silbergehalten ohne Ausscheidungen von Silber, Palladium und binären Silber-Palladium-Verbindungen zu erhalten, die zu den überraschend vorteilhaften physikalischen Eigenschaftskombinationen führt, die für Prüfnadeln und Schleifkontakten derart vorteilhaft sind.

Es konnten sogar elektrische Leitfähigkeiten von 27% und 28% IACS erreicht werden, wenn eine Palladium-Kupfer-Silber-Legierung mit Ruthenium hergestellt und gemessen wird. Eine überraschend hohe Härte konnte erzielt werden.

Mit der vorliegenden Erfindung sind elektrische Leitfähigkeiten von 27% IACS oder sogar mehr möglich. 100% IACS entsprechen 58 m / (Ohm mm²).

Die Verwendung von Ruthenium oder Rhodium als Legierungsbestandteil von Palladium-Kupfer-Silber-Legierungen ist im Vergleich zur Verwendung von Rhenium aufgrund der unterschiedlichen chemischen Eigenschaften dieser Elemente überraschend. Verglichen mit Rhenium befinden sich Rhodium und Ruthenium sowohl in einer anderen Hauptgruppe als auch in einer anderen Periode des Periodensystems, was in erster Näherung auf sehr unterschiedliche Eigenschaften und unterschiedliches Legierungsverhalten schließen lässt. Rhodium und Ruthenium sind Platingruppenmetalle, während Rhenium zur Mangangruppe zählt, weshalb auch deshalb keine Eigenschaftsähnlichkeit erwartbar ist. Rhenium besitzt eine hexagonale Kristallstruktur während Rhodium kubisch flächenzentriert ist.

Ruthenium hat eine geringere Löslichkeit in Silber als Rhenium (2,65 x 10⁻⁴ bei Ruthenium im Vergleich zu 1,44 x 10⁻³ bei Rhenium). Dies sollte einen positiven Effekt auf die elektrische Leitfähigkeit der erfindungsgemäßen Palladium-Kupfer-Silber-Legierung haben. Zudem wurden bei elektronenmikroskopischen Untersuchungen in Palladium-Kupfer-Silber-Legierungen mit 1,1 Gew% bis 1,5 Gew% Ruthenium Ruthenium-Ausscheidungen an den Korngrenzen gefunden. Diese können durch Ausscheidungshärtung zu einer größeren Härte der Palladium-Kupfer-Silber-Legierung führen.

Die erfindungsgemäße Palladium-Kupfer-Silber-Legierung mit der B2-Kristallstruktur zeichnet sich durch eine hohe Härte, gute Federeigenschaften und gleichzeitig gute elektrische Leitfähigkeit aus. Sie ist daher für eine Anwendung als Material zur Herstellung von Prüfnadeln prädestiniert. Der Einbau von größeren Anteilen von Silber in die Überstruktur der B2-Kristallstruktur scheint die elektrische Leitfähigkeit der Palladium-Kupfer-Silber-Legierung verbessert zu haben, wobei bei derartigen Silbergehalten eigentlich keine oder nur geringe Anteile der B2-Kristallstruktur erwartet werden konnten. Insbesondere fehlen überraschend die Silber-Palladium-Ausscheidungen, die eigentlich in der Palladium-Kupfer-Silber-Legierung zu erwarten gewesen wären, wodurch die Härte und die Federeigenschaften der entsprechenden Palladium-Kupfer-Silber-Legierung besser sind, als es aufgrund der Erkenntnisse aus dem Stand der Technik zum ternären Cu-Ag-Pd-Phasendiagramm eigentlich zu erwarten gewesen wäre.

Bei einem Gewichtsverhältnis (1,05 bis 1,6) von Palladium und Kupfer kann durch entsprechende Wärmebehandlung und dünnes Auswalzen die Palladium-Kupfer-Silber-Legierung mit der B2-Kristallstruktur mit einer geringen mittleren Korngröße eingestellt werden. Die geordnete B2-Kristallstruktur der Palladium- und Kupfer-Atome hat zusammen mit der geringen mittleren Korngröße zur Folge, dass sowohl die Härte als auch die elektrische Leitfähigkeit der Palladium-Kupfer-Silber-Legierung ansteigen. Die Zulegierung von Silber im Verhältnis Palladium zu Silber ermöglicht durch eine Ausscheidungshärtung eine zusätzliche Steigerung der Festigkeit. Die Zulegierung von Ruthenium, Rhodium, Rhenium oder Mischungen davon in der Größenordnung von 1 Gew% bis 6 Gew% und das Auswalzen zu dünnen Schichten tragen überraschend zur Bildung einer besonders geringen mittleren Korngröße der Palladium-Kupfer-Silber-Legierung mit der B2-Kristallstruktur bei, was Härte und Umformbarkeit der Palladium-Kupfer-Silber-Legierung positiv beeinflusst. Zudem verhindert das Ruthenium, Rhodium, Rhenium oder deren Mischung, die mutmaßlich bevorzugt an den Korngrenzen angeordnet sind, Kornwachstum und Kriechen bei der Einsatztemperatur. Dies bewirkt eine längere Haltbarkeit daraus gefertigter Prüfnadeln. Die erreichte elektrische Leitfähigkeit ist bei 27% bis 30 % IACS bei einer Härte von mehr als 400 HV besonders gut für den Einsatz als Prüfnadel geeignet. Damit sind die physikalischen Eigenschaften der erfindungsgemäßen Palladium-Kupfer-Silber-Legierung mit Ruthenium bezüglich elektrischer Leitfähigkeit und Härte auch besser als die von Paliney® 25 der Firma Deringer Ney.

Im Folgenden werden Ausführungsbeispiele der Erfindung erläutert, ohne jedoch dabei die Erfindung zu beschränken.

Die nachfolgend beschriebenen Palladium-Kupfer-Silber-Legierungen wurden hergestellt, indem zunächst Vorlegierungen durch Induktionsschmelzen erzeugt wurden. Als Vorlegierungen wurden Palladium-Ruthenium-, Palladium-Rhenium- und Palladium-Rhodium-Vorlegierungen hergestellt. Die Herstellung der Vorlegierungen ist aufgrund der nicht zu stark voneinander abweichenden Schmelztemperaturen und Dichten der Elemente Palladium, Ruthenium und Rhodium unproblematisch und ohne großen Aufwand kostengünstig möglich.

Diese Vorlegierungen wurden anschließend mit Kupfer und Silber durch Vakuuminduktionsschmelzen legiert. Der Schmelztiegel wird kalt chargiert, die Vakuumkammer verschlossen und abgepumpt, bis der Taupunkt bei -55 °C oder darunter liegt. Während dessen wird das Material vorgewärmt aber noch nicht aufgeschmolzen. Beim Erreichen des Taupunkts (nach etwa 30 min) wird die Vakuumkammer mit 50 mbar Argon-Partialdruck beaufschlagt und das Material aufgeschmolzen. Der Partialdruck ist notwendig um ein Abdampfen des Silbers zu verhindern, was die Legierungszusammensetzung verändern würde. Der Abguss erfolgt relativ kalt (ca. 50 K über dem Schmelzpunkt der Legierung) in eine ungekühlte Cu-Kokille. Die Gusshaut des Barrens kann mittels fräsen oder auch auf andere Weise entfernt werden. Anschließend werden die so erschmolzenen Barren durch Wärmebehandlungen und Walzen geformt und gehärtet. Hierzu wurden die Barren zweimal für 60 Minuten und einmal für 45 Minuten bei 900 °C in einer CO-Atmosphäre getempert und in Wasser abgeschreckt. Dazwischen erfolgte ein Umformen um 60% und um weitere 50% mittels Walzen. Anschließend erfolgen weitere derartige Glüh- und Walzschritte. Wobei als letzter Schritt das Material an 20 $\mu$m bis 100 $\mu$m gewalzt und anschließend bei 380 °C für zumindest 4 Minuten ausgelagert, wodurch ein Härtungseffekt eintritt und eine gute elektrische Leitfähigkeit erzielt wird. Anschließend wurden die elektrische Leitfähigkeit mit einer Vierpunktmessung bestimmt. Die Vierpunkt-Messmethode, auch Vierpunktmessung oder Vierspitzenmessung, ist ein Verfahren, um den Flächenwiderstand, also den elektrischen Widerstand einer Oberfläche oder dünnen Schicht, zu ermitteln. Bei dem Verfahren werden vier Messspitzen in einer Reihe auf die Oberfläche der Folie gebracht, wobei über die beiden äußeren Messspitzen ein bekannter Strom fließt und mit den beiden inneren Messspitzen der Potentialunterschied, das heißt, die elektrische Spannung zwischen diesen beiden inneren Messspitzen, gemessen wird. Da das Verfahren auf dem Prinzip der Vierleitermessung beruht, ist es weitgehend unabhängig vom Übergangswiderstand zwischen den Messspitzen und der Oberfläche (Prinzip Thomson-Brücke). Benachbarte Messspitzen haben jeweils den gleichen Abstand. Der Flächenwiderstand R ergibt sich aus der gemessenen Spannung U und dem Strom I nach der Formel:

$$R = \frac{\pi}{\ln 2} \frac{U}{I}$$

Um aus dem Flächenwiderstand R den spezifischen Widerstand p des Schichtmaterials zu errechnen, multipliziert man ihn mit der Dicke d (Schichtdicke) der Folie:

$$\rho = d\,R$$

Die elektrische Leitfähigkeit ergibt sich aus dem Kehrwert des spezifischen Widerstands.

Die Härte wird nach HV0,05 - Vickers Härteprüfung nach DIN EN ISO 6507-1:2018 bis -4:2018 mit einer Prüfkraft von 0,490 N (0,05 Kilopond) durchgeführt. Die Festigkeit wurde mittels Zugversuchen und die Mikrostruktur mittels metallographischen Schliffen untersucht.

Die Bestimmung der mittleren Korngröße erfolgt entsprechend oder analog nach DIN EN ISO 643:2019, korrigierte Fassung 2020-03 / Deutsche Fassung ISO 643:2020 vom Juni 2020, wobei der Mittelwert von Linienschnittsegmenten eines Querschliffs bestimmt wird. Die Probenvorbereitung erfolgt wie in der Norm beschrieben, obwohl es sich vorliegend bei der Palladium-Kupfer-Silber-Legierung nicht um einen Stahl handelt. Das Ätzverfahren kann auf die chemische Beständigkeit der Palladium-Kupfer-Silber-Legierung angepasst werden, so dass die Korngrenzen der Körner der Palladium-Kupfer-Silber-Legierung möglichst gut sichtbar sind. Sofern die Palladium-Kupfer-Silber-Legierung bei der Herstellung gewalzt wurde, wird der zu untersuchende Querschliff parallel zu der von den Walzen ausgeübten Kraft geschnitten und geschliffen und poliert.

Für die Präparation der Probe für die Transmissions-Elektronen-Mikroskop-Untersuchungen (TEM-Untersuchungen) wurde ein Zeiss Crossbeam 540 XB (Zeiss GmbH, Oberkochen, Deutschland) verwendet, kombiniert mit einer Gemini2-Elektronensäule und mit einem Capella Focused Ion Beam (FIB) mit Ga+ Ionen. Zur Untersuchung wurden die Proben vorbereitet, indem zunächst ein Auftragen einer 2 $\mu$m dicken Pt-Schutzschicht auf die Oberfläche erfolgt. Dann wurde in-situ ein Lift-out einer Lamelle mit der Dicke 1 $\mu$m (Länge 15 $\mu$m und Höhe bis zu 10 $\mu$m) senkrecht zur Walzrichtung und Transfer auf ein Mo-TEM Grid (Molybdän-TEM-Gitter) durchgeführt. Danach erfolgt ein Dünnen mit dem FIB bis die TEM Lamelle für Elektronen komplett durchscheinend ist. Dafür wird sowohl die Beschleunigungsspannung als auch die Stromstärke der FIB Ströme sukzessive reduziert (von 30 kV auf 10 kV und 5 kV; und von 300 pA schrittweise auf 10 pA). Die Enddicke wurde dann kleiner als 100 nm eingestellt, da sonst die Folie nicht durchscheinend ist. Beugungsbilder wurden mit einem Philips CM200 TEM bei 200 kV Beschleunigungsspannung aufgenommen

Transmissionselektronenmikroskopische Untersuchungen wurden an einem doppelt aberrationskorrigierten FEI Titan3 Themis 80-300 bei einer Beschleunigungsspannung von 300 kV durchgeführt. Die Probe wurde auf einem "low-profile" Doppelkipphalter von FEI montiert, welcher mitunter energiedispersive Röntgenspektroskopie (EDXS) Messungen mit minimierter Streustrahlung ermöglicht. Zur Bildgebung im STEM-Modus (scanning transmission electron microscopy = Rastertransmissionselektronen-mikroskopie-Modus) kamen Solid-State-Detektoren (Silizium-Halbleiterdetektoren) zum Einsatz, die ringförmig und konzentrisch zueinander angeordnet sind und integral das Signal der gestreuten Elektronen in einem bestimmten Streuwinkelbereich messen.

Im "nanodiffraction mode" werden Beugungsbilder nicht unter parallelen Beleuchtungsbedingungen erzeugt, sondern der auf die Probe einfallende Elektronenstrahl wird konvergent eingestellt (mit einem kleinen Konvergenzwinkel, hier 0,36 mrad für den halben Konvergenzwinkel). Das verwendete TEM (FEI Titan) ist mit einer speziellen Kondensor-Blende der Nutzereinrichtung für Nanowissenschaften "Molecular Foundry" am Lawrence Berkeley National Laboratory in Berkeley, Kalifornien, USA, ausgestattet, welche für diese Messungen verwendet wurde. Dadurch, dass der Elektronenstrahl so auf einem Punkt der Probe konvergent "zusammengezogen" wird, kann ein Beugungsbild von genau dieser Probenposition aufgenommen werden. Aufgrund des konvergenten Strahls sind statt Beugungspunkten dann Scheibchen mit entsprechendem Winkeldurchmesser im Beugungsbild zu sehen. Beugungsbilder wurden mit einer Ceta-Kamera (4096 x 4096 Pixel CMOS Sensor; physikalische Pixelgröße 14 x 14 pm$^2$; Belichtungszeit 12,5 bis 1000 ms; gewählte Auflösung 512x512 bis 2048x2048 Pixel) aufgenommen.

Wird unter diesen Bedingungen im STEM-Modus ein definierter Probenbereich abgerastert, kann durch die Wahl der STEM-Detektoren und der Kameralänge genau eingestellt werden, welche dieser Reflexe (anhand ihrer Beugungswinkel) zum Bild beitragen sollen. Hier war es möglich, bei einer Kameralänge von 115 bzw. 145 mm unter Verwendung eines DF2-Detektors (Dunkelfeld-Detektor - abgeschattet durch einen DF4-Detektor) einen inneren Ring von Reflexen zu isolieren, die keine fundamentalen, sondern ausschließlich Überstrukturreflexe sind. Somit erscheinen in diesen STEM-Bildern nur Bereiche hell, die eine Überstruktur mit diesem Beugungsreflex aufweisen.

Um im STEM-Modus zusätzlich energiedispersive Röntgenspektroskopie (EDXS) durchzuführen, kam das Röntgendetektorsystem SuperXG2 zum Einsatz, bestehend aus vier Detektorsegmenten, die in jeweils einem Quadranten oberhalb der Probe ringsherum angeordnet sind. Durch die Kombination mit STEM kann für jeden abgerasterten Pixel ein eigenes Röntgenspektrum aufgenommen werden und somit können Elementverteilungskarten (maps) erstellt werden. Für diese Aufnahme wurden alle vier Detektorsegmente aktiviert, und der Energiebereich der Detektion auf 20 keV mit einer Dispersion von 5 eV eingestellt. Während der Aufnahmedauer von insgesamt ca. 125 min wurden 145 Frames (Auflösung 780x642 Pixel) aufgenommen, die Aufnahmedauer pro Frame betrug 51,4 s bei einer Verweildauer (dwell time) pro Pixel von 100 ps. Der Datensatz wurde unter Nanobeugungs-Bedingungen aufgenommen, um eine Korrelation mit Regionen mit Überstruktur (hell in DF2) zu ermöglichen.

Die Quantifizierung der Elementkonzentrationen in Atom-Prozent (at%) erfolgte mittels eines automatischen Spektrum-Fits, bei dem modellierte Element-Peaks und Hintergrundsignal an das gemessene Spektrum angepasst werden. Hierbei wurden die Standardeinstellungen (Linien/Familien) für jedes Element verwendet und eine empirische Hintergrundkorrektur ausgewählt; die Daten wurden vor der Quantifizierung räumlich vorgefiltert (pre-filtering) mit 4-Pixel-Durchschnittsfilter (average filter) und nach der Quantifizierung nachgefiltert (post-filtering) ebenfalls mit 4-Pixel-Durchschnittsfilter. Alle anderen Einstellungen wurden bei ihren Standardwerten belassen.

Für die Quantifizierung der Probenzusammensetzung wurden die in der Legierung erwarteten Elemente (Cu, Ru, Pd, Ag) ausgewählt. Zur Dekonvolution (Entfaltung) des gemessenen Spektrums wurden neben diesen Elementen noch weitere berücksichtigt, die potentiell Artefakte im Spektrum verursachen, welche aber nicht von der Legierung selbst stammen: organische Kontaminierung/Oxidation (C, O); im Probenhalter verwendete Abstandsringe (Al); Material des Halbleiterdetektors (Si); Bauteile in der TEM-Säule (Fe); Ionenimplantation/Materialdeposition während der FIB-Lamellenpräparation (Ga, Pt); TEM-Grid, welches die Lamelle hält (Mo). Diese Elemente werden also beim Spektrum-Fit berücksichtigt, aber nicht bei der Berechnung der Probenzusammensetzung, wo ihre Konzentration als 0 angenommen wird.

Die Auswertung aller TEM-Daten erfolgte mit der Software Velox (Version 3.3.0.885-810c504366). Diese umfasst die Auswahl von Bildbereichen, Messungen von Abständen in Bildern, Anpassung von Helligkeit/Kontrast, Quantifizierung von Elementkonzentrationen sowie den Export als 8-/16-bit-TIFF-Dateien ggf. mit Datenbalken.

Zusätzlich kam zur Simulation von erwarteten Beugungsbildern der B2-Kristallstruktur sowie von Ringmustern die Software JEMS (Java Electron Microscopy Software, Version 4.8330U2019b20) zum Einsatz. Dafür wurde zunächst eine Einheitszelle basierend auf der B2-Kristallstruktur generiert, die Atompositionen mit Cu bzw. Pd besetzt und ein Gitterparameter von a=0,2977 nm eingestellt. Hiervon wurden mit der Funktion "Draw diffraction pattern" Beugungsbilder in verschiedenen Zonenachsen generiert und mit den experimentellen verglichen. Ein quantitativer Vergleich basierend auf der Methode der Quotienten erfolgte jeweils anhand von zwei Beugungspunkten im experimentellen Beugungsbild und den entsprechenden in der Simulation. Stimmen der Winkel zwischen beiden Punkten bzgl. Nullstrahl (hier immer 90°) sowie der Quotient der Abstände zum Nullstrahl gut überein, weist dies auf eine Übereinstimmung der Zonenachsen hin.

Es wurde eine Palladium-Kupfer-Silber-Legierungen mit der Zusammensetzung 51,5 Gew% Palladium, 36,5 Gew% Kupfer, 10,5 Gew% Silber und 1,5 Gew% Ruthenium (Pd51,5Cu36,5Ag10,5Ru1,5 Legierung) nach dem zuvor genannten Verfahren hergestellt und auf 20 μm bis 100 μm gewalzt. Zudem enthalten die Legierungen übliche Verunreinigungen mit einer Konzentration von weniger als 0,1 Gew%. Anschließend wurde die Legierung bei 380 °C für 4 Minuten ausgelagert (SHT - Short Heat Treatment), für 3 Stunden ausgelagert (LHT - Long Heat Treatment) oder lösungsgeglüht und nicht bei 380 °C ausgelagert (SA - Solution Annealing). Es wurden drei unterschiedliche Pd51,5Cu36,5Ag10,5Ru1,5 Legierungen (SHT, LHT, SA) untersucht, die sich durch die Zeitdauer des Temperns bei 380 °C unterscheiden, nämlich bei 4 Minuten, 3 Stunden und nicht bei 380 °C getempert. Bei der nicht bei 380 °C getemperten Pd51,5Cu36,5Ag10,5Ru1,5 Legierung SA wurde als letzte Temperaturbehandlung somit eine Temperatur von über 750 °C (vorliegend bei 900 °C) eingesetzt.

Die so hergestellten Pd51,5Cu36,5Ag10,5Ru1,5 Legierungen SHT und LHT weisen eine elektrische Leitfähigkeit von 27% IACS (15,7 $\cdot$ 10$^6$ S/m) und eine Härte von 380 HV0,05 auf. Im Folgenden werden Messergebnisse, die an Pd-Cu-Ag-Legierungen gewonnen wurden, anhand von zwölf Figuren erläutert. Dabei zeigt:

Figur 1: ein Elektronenbeugungsbild bei 265 mm Kameralänge einer Pd51,5Cu36,5Ag10,5Ru1,5 Legierung SHT, die zum Abschluss für 4 Minuten bei 380 °C ausgelagert wurde, wobei die bei den entsprechenden Winkeln zu erwartenden Beugungsreflexe der B2-Kristallstruktur (CuPd) und einer fcc-Struktur (Cu) als Ringe eingezeichnet sind;

Figur 2: ein Elektronenbeugungsbild bei 265 mm einer Pd51,5Cu36,5Ag10,5Ru1,5 Legierung LHT, die zum Abschluss für 3 Stunden bei 380 °C ausgelagert wurde, wobei die bei den entsprechenden Winkeln zu erwartenden Beugungsreflexe der B2-Kristallstruktur (CuPd) und der fcc-Struktur (Cu) als Ringe eingezeichnet sind;

Figur 3: ein Elektronenbeugungsbild bei 1680 mm Kameralänge einer Pd51,5Cu36,5Ag10,5Ru1,5 Legierung SA, die zum Abschluss nicht geglüht wurde, damit also abschließend lösungsgeglüht ist und keine B2-Kristallstruktur aufweist, wobei die bei den entsprechenden Winkeln zu erwartenden Beugungsreflexe der fcc-Struktur (Cu) eingezeichnet sind;

Figur 4: eine XRD-Analyse der Legierungen LHT und SA nach den Figuren 2 und 3;

Figur 5: ein Nano-Beugungsbild mit konvergentem Elektronenstrahl eines Korns der Pd51,5Cu36,5Ag10,5Ru1,5 Legierung LHT nach Figur 3 in Richtung der 203-Zonenachse, mit daraus bestimmten Gitterparametern;

Figur 6: ein Nano-Beugungsbild mit konvergentem Elektronenstrahl eines Korns der Pd51,5Cu36,5Ag10,5Ru1,5 Legierung LHT nach Figur 3 in Richtung der 102-Zonenachse, mit daraus bestimmten Gitterparametern;

Figur 7: eine durch EDX-Mapping gewonnene Elementverteilungskarte von Silber (Ag) der Pd51,5Cu36,5Ag10,5Ru1,5 Legierung LHT nach Figur 3;

Figur 8: eine durch EDX-Mapping gewonnene Elementverteilungskarte von Ruthenium (Ru) der Pd51,5Cu36,5Ag10,5Ru1,5 Legierung LHT im gleichen Bildausschnitt wie Figur 7;

Figur 9: eine durch EDX-Mapping gewonnene Elementverteilungskarte von Palladium (Pd) der Pd51,5Cu36,5Ag10,5Ru1,5 Legierung LHT im gleichen Bildausschnitt wie Figur 7;

Figur 10: eine durch EDX-Mapping gewonnene Elementverteilungskarte von Kupfer (Cu) der Pd51,5Cu36,5Ag10,5Ru1,5 Legierung LHT im gleichen Bildausschnitt wie Figur 7;

Figur 11: eine elektronenmikroskopische STEM-Aufnahme über den Bereich der Pd51,5Cu36,5Ag10,5Ru1,5 Legierung LHT die in den Figuren 7 bis 10 gescannt wurde; und

Figur 12: eine XRD-Analyse der Legierung LHT nach Figur 2 mit den für die B2-Struktur charakteristischen Reflexen.

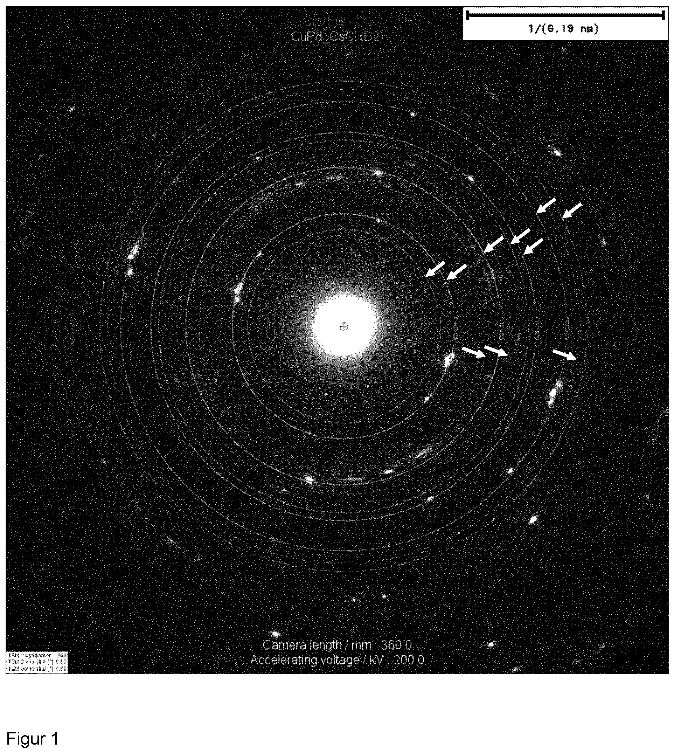

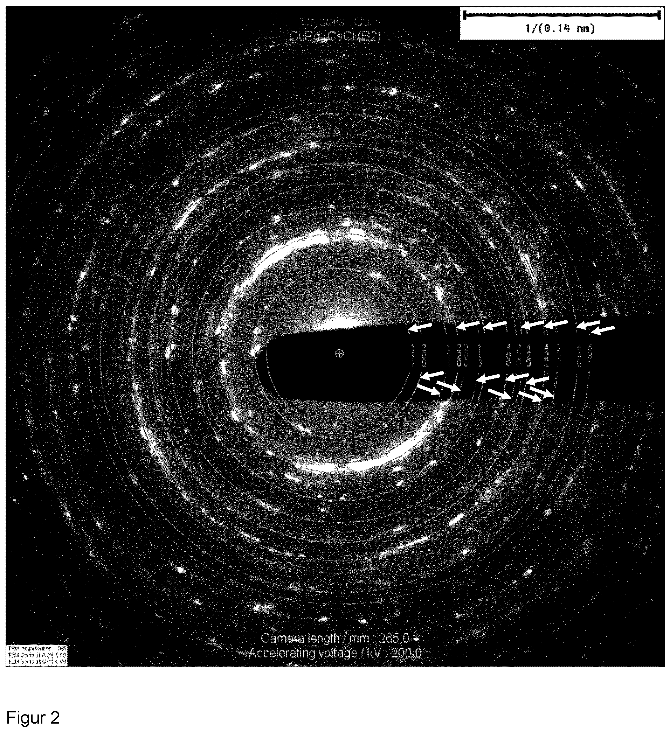

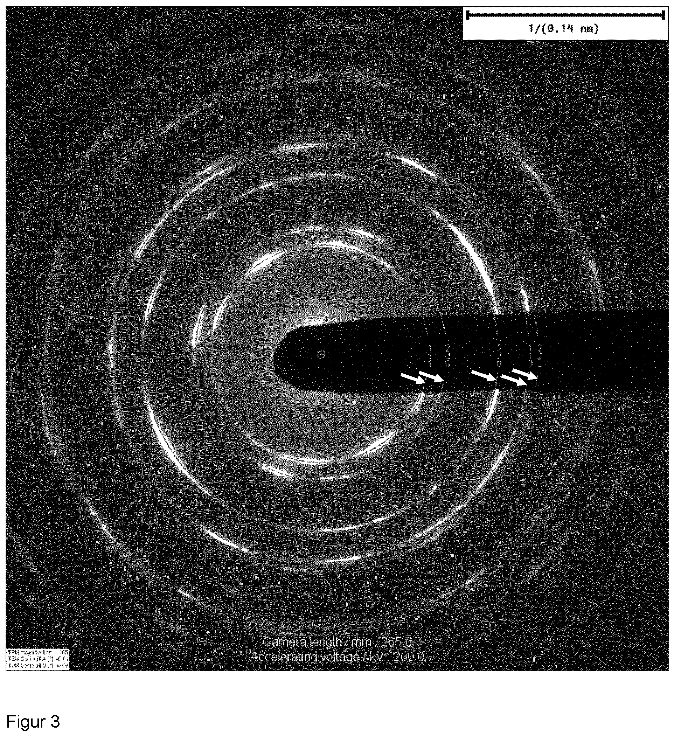

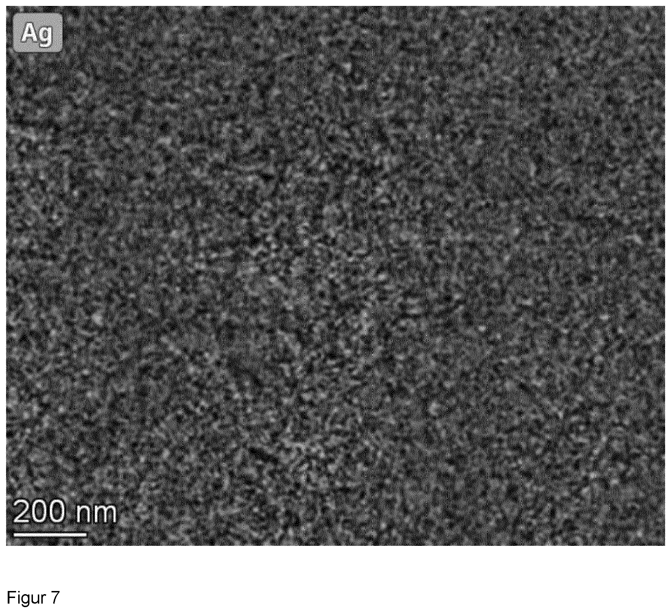

Die Reflexe beziehungsweise Ringe der Elektronenbeugungsbilder der STEM-Untersuchungen zeigen, dass sich in den beiden Pd51,5Cu36,5Ag10,5Ru1,5 Legierungen SHT und LHT die B2-Kristallstruktur ausbildet (siehe Figuren 1 und 2). Die Ringe der B2-Kristallstruktur, die mit einer B2-Kristallstruktur (CuPd) modelliert wurden, sind mit nach links weisenden weißen Pfeilen gekennzeichnet. Die Ringe einer anderen Struktur, die als fcc-Struktur (Cu) angenommen und modelliert wurde, sind mit nach rechts weisenden weißen Pfeilen gekennzeichnet. Die B2-Struktur entspricht der CsCl-Struktur und nur deshalb wurde diese generische Bezeichnung (CsCl) in den Figuren 1 und 2 zusätzlich zu CuPd verwendet. Selbstverständlich ist kein CsCl in den Legierungen LHT und SHT zu erwarten. Zudem wurde lediglich die Bezeichnung CuPd für die Modellierung verwendet, obwohl es sich um eine B2-Kristallstruktur enthaltend zusätzlich Silber und auch in geringem Umfang Ruthenium neben Kupfer und Palladium handelt, wie im Folgenden durch EDXS-Mapping bestätigt werden konnte (siehe Figuren 7 bis 10). Auch wurde die fcc-Struktur lediglich mit der Struktur von Kupfer modelliert und es handelt sich dabei nicht um reines Kupfer. Bei der Pd51,5Cu36,5Ag10,5Ru1,5 Legierung SA ist dagegen keine B2-Kristallstruktur erkennbar (siehe Figur 3). Dort wurde ausschließlich die als fcc-Struktur (Cu) angenommene und entsprechend modellierte andere Struktur gefunden. Die Ringe der fcc-Struktur sind in Figur 3 mit nach rechts weisenden weißen Pfeilen gekennzeichnet. Die gefundenen Ringe der Proben SHT und LHT lassen sich vor allem durch die von der B2-Kristallstruktur berechneten Ringe identifizieren (siehe die nach links weisenden weißen Pfeile), was am deutlichsten bei der für lange Zeit getemperten Pd51,5Cu36,5Ag10,5Ru1,5 Legierung (LHT) zu erkennen ist (siehe Figur 2).

Neben der B2-Kristallstruktur sind bei der Pd51,5Cu36,5Ag10,5Ru1,5 Legierung LHT noch eine oder mehrere andere Phasen insbesondere die als fcc-Struktur angenommene Phase erkennbar, da manche der experimentell beobachteten Ringe nicht von der B2-Kristallstruktur abgedeckt sind. Die Fremdphase könnte eine kubisch flächenzentrierte Struktur (fcc) haben. Die Ringe, die nicht auf die B2-Kristallstruktur zurückzuführen sind, sind alle sehr schwach, so dass von der anderen Phase (evtl. fcc) im gemessenen Ausschnitt wohl nur ein kleiner Anteil vorhanden ist.

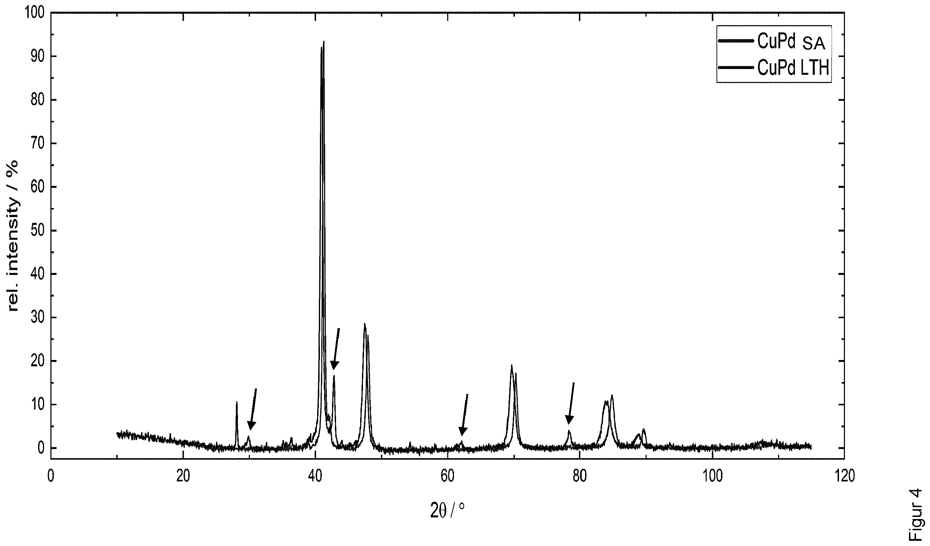

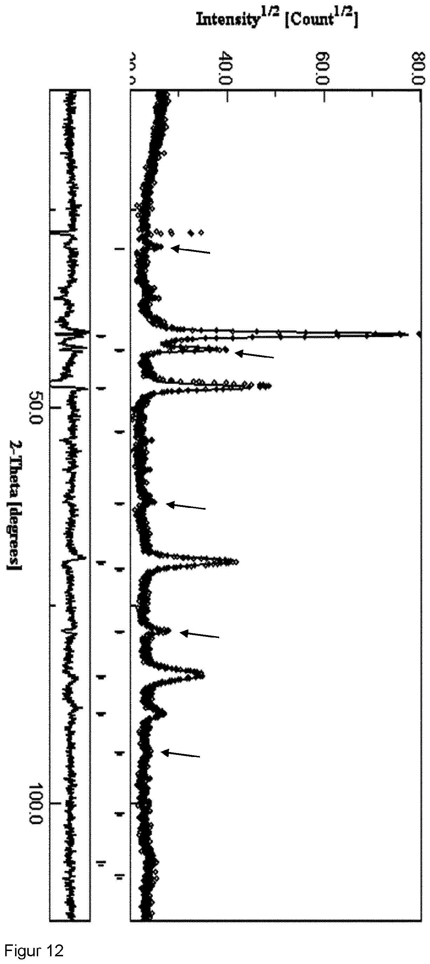

Die B2-Kristallstruktur in der Pd51,5Cu36,5Ag10,5Ru1,5 Legierung LHT ist auch in den XRD-Untersuchungen nach Figur 4 und Figur 12 zu erkennen (die entsprechenden Reflexe sind mit Pfeilen markiert), während die Pd51,5Cu36,5Ag10,5Ru1,5 Legierung SA keine B2-Kristallstruktur zeigt (die Reflexe fehlen dort vollständig - siehe Figur 4). In Figur 4 sind Röntgen-Diffraktogramme der Pd51,5Cu36,5Ag10,5Ru1,5 Legierungen SA (in Figur 4 zu etwas höheren Winkeln 2Θ nach rechts verschoben) und LHT (in Figur 4 zu etwas geringeren Winkeln 2Θ nach rechts verschoben) dargestellt. Bei der LHT Legierung sind Anteile einer Fremdphase mit kubisch flächenzentrierter Kristallstruktur als Hauptkomponente zu erkennen. Die SA Legierung zeigt ausschließlich diese kubisch flächenzentrierte Kristallstruktur. Figur 12 zeigt die XRD-Aufnahme der Pd51,5Cu36,5Ag10,5Ru1,5 Legierung LHT isoliert und mit den für die B2-Kristallstruktur typischen Reflexen dargestellt, wobei die für die B2-Kristallstruktur typischen Reflexe durch die Pfeile in Figur 12 markiert sind. Die in Figur 12 zu erkennenden Reflexe der B2-Kristallstruktur lassen den Schluss zu, dass der Anteil der B2-Kristallstruktur in der der Pd51,5Cu36,5Ag10,5Ru1,5 Legierung LHT deutlich über 1 Vol% liegt und auch über 5 Vol% liegt.

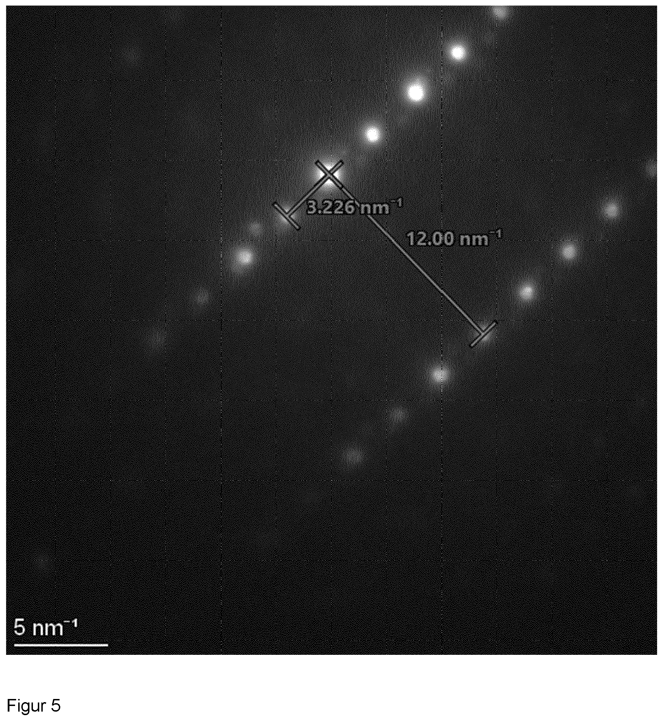

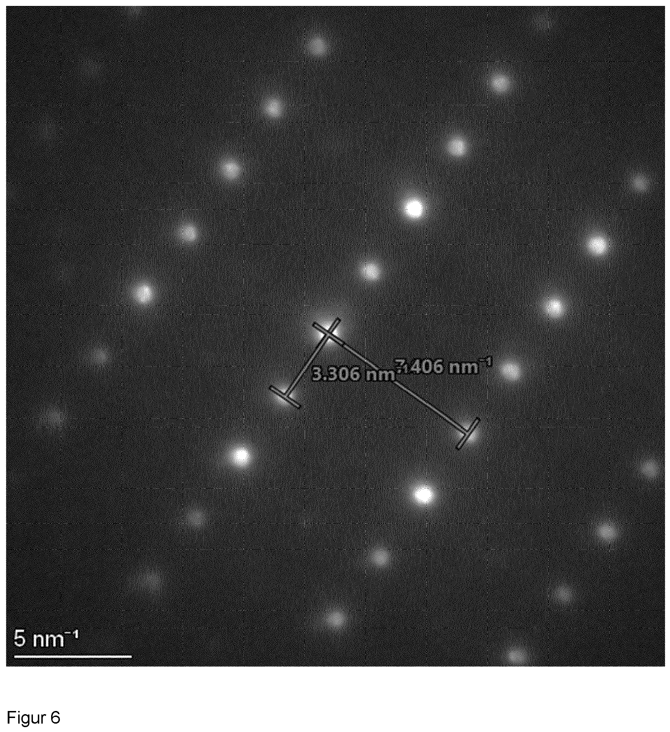

Mittels TEM wurden mit einem konvergenten Elektronenstrahl Körner der B2-Kristallstruktur in der Pd51,5Cu36,5Ag10,5Ru1,5 Legierungen LHT gemessen (siehe Figuren 5 und 6, die verschiedene Zonenachsen des Kristallgitters der B2-Kristallstruktur zeigen). Die Beugungsmuster wurden in verschiedenen Zonenachsen (ZA) in den hellen Bereichen der STEM Bilder aufgenommen, wo die B2-Kristallstruktur erwartet wurde. Alle ElektronenBeugungsbilder und die berechneten Gitterabstände, die in die Figuren 5 und 6 eingezeichnet sind, sind konsistent mit der B2-Kristallstruktur. Dies ist durch einen Vergleich des experimentellen Musters mit der jeweiligen Simulation basierend auf der Quotientenmethode erkennbar. Derartige Verfahren sind dem Fachmann aus der Literatur bekannt (siehe beispielsweise "Werkstoffkunde Grundlagen Forschung Entwicklung" Prof. Dr. Eckard Macherauch und Prof. Dr. Volkmar Gerold (Vieweg Verlag) - Band 1: "Einführung in die Elektronenmikroskopie Verfahren zur Untersuchung von Werkstoffen und anderen Festkörpern" Manfred von Heimendahl (1970), Kapitel 3.5. "Methode der Quotienten von Rn" (Seite 91ff) und "Cu-Pd (Copper-Palladium) P.R. Subramanian, D.E. Laughlin, Phase Diagram Evaluations: Section II, Seite 236, Tabelle 7 "Lattice Parameters of Ordered CsCl-Type CuPd " from [39Jon] → 50.0 % = 0.2977, Journal of Phase Equilibria Vol. 12, No. 2, 1991). Eine genaue Kalibrierung der Kathodenlumineszenz (cathodoluminescence - CL) ist dabei nicht wichtig, da hier nur das Verhältnis zweier gemessener reziproker Abstände von Interesse ist. Der Winkel zwischen allen gemessenen Abstandspaaren beträgt 90°. Die Absolutwerte der Gitterparameter sind hier nicht relevant, sondern nur das Verhältnis zwischen den beiden Gitterparametern eines Bilds, da die Kameralänge der Simulation (also die "Vergrößerung") nicht 1:1 kalibriert war. Außerdem scheinen manche Ringe leicht verbreitert, so dass nicht alle Reflexe exakt auf dem zugehörigen Ring liegen. Das könnte möglicherweise durch lokale interne Spannungen oder Variationen in der Zusammensetzung verursacht werden.

Durch den Nachweis mehrerer verschiedener Zonenachsen der B2-Kristallstruktur konnte das Vorliegen dieser B2-Kristallstruktur in der Probe nachgewiesen und damit belegt werden. Zudem ist eine Übereinstimmung mit den XRD-Messungen ersichtlich. Um die Herkunft der verschiedenen Beugungsringe im aufgenommenen Ringmuster zu klären, wurde in JEMS unter "Crystal > Structure Factor" die Funktion "Draw ring diffraction pattern" genutzt und damit schematisch die zu erwartenden Radien der einzelnen Ringe über das im TEM aufgenommene Ringmuster gelegt (siehe Figur 2). Zusätzlich zu den erwarteten Ringen der B2-Kristallstruktur (a=0,2977 nm) wurden hier die Ringe einer möglichen fcc-Matrix (a=0,365 nm für Cu) berücksichtigt.

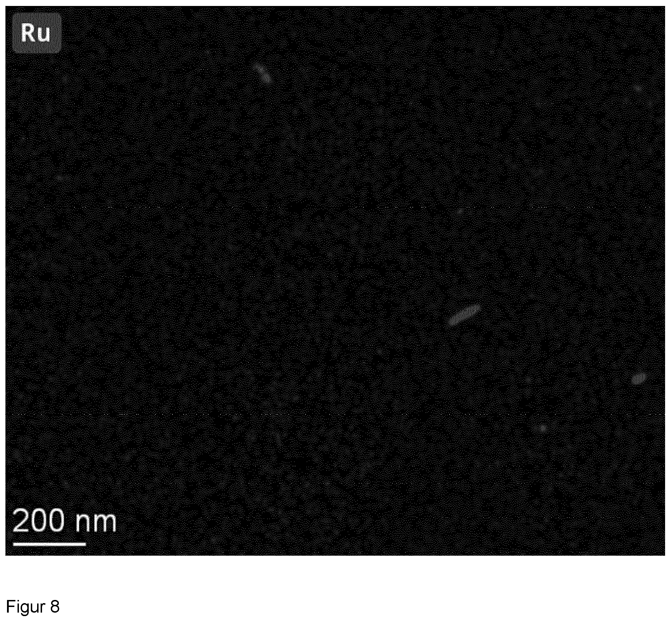

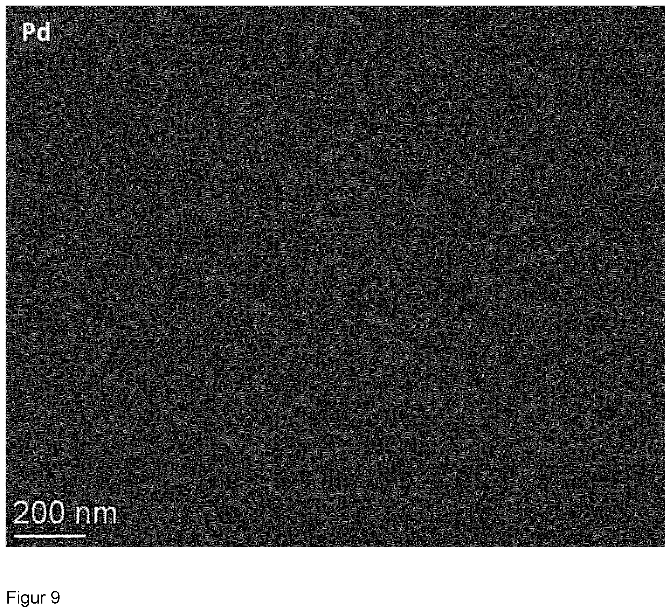

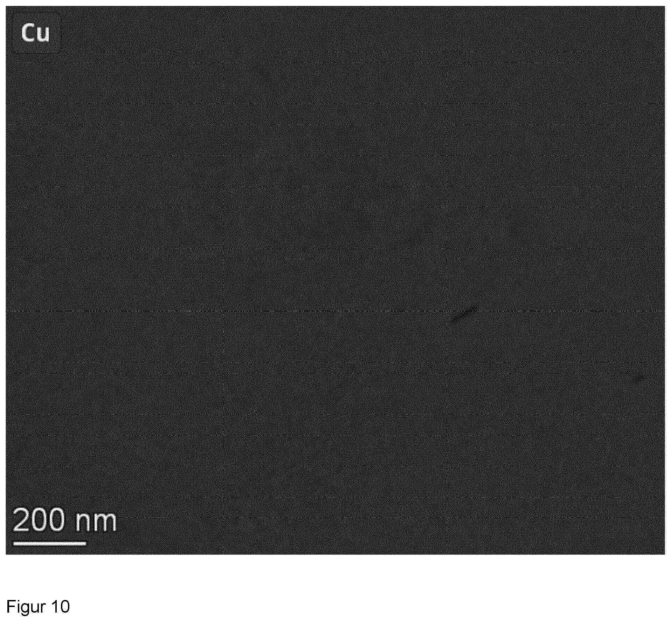

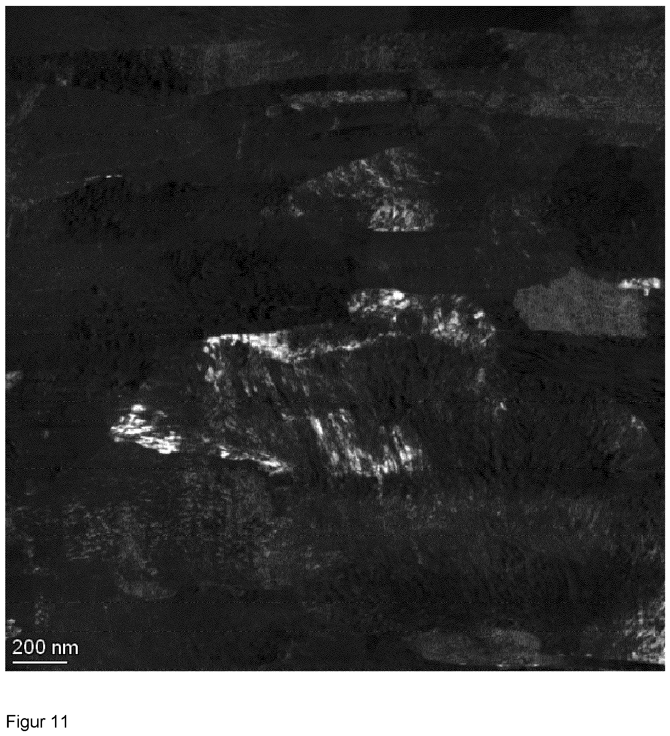

Des Weiteren wurde mittels EDXS-Mapping die Verteilung von Silber (Figur 7), Ruthenium (Figur 8), Palladium (Figur 9) und Kupfer (Figur 10) in einer Schnittfläche durch die Pd51,5Cu36,5Ag10,5Ru1,5 Legierung LHT bestimmt. Der Bildausschnitt hierzu ist in Figur 11 gezeigt. Anhand der Bilder lässt sich erkennen, dass geringe Mengen von Ruthenium-Ausscheidungen vorhanden sind und ansonsten die Elemente weitgehend gleich verteile sind. Insbesondere ist das Silber in der Pd51,5Cu36,5Ag10,5Ru1,5 Legierung gleichmäßig verteilt, was ausgehend von den aus dem Stand der Technik bekannten Untersuchungen zum ternären Phasendiagramm überraschend ist. Hierdurch können eine hohe elektrische Leitfähigkeit und eine hohe Bruchfestigkeit der Pd51,5Cu36,5Ag10,5Ru1,5 Legierung erreicht werden.

In den Messungen des EDXS-Mappings konnten keine Ausscheidungen von Silber, von Palladium oder von binären Silber-Palladium-Verbindungen nachgewiesen werden, da das Kupfer in der Pd51,5Cu36,5Ag10,5Ru1,5 Legierung LHT außer in den Ruthenium-Einschlüssen flächendeckend nachzuweisen ist (siehe Figur 10) und da auch die Verteilung von Palladium und von Silber in der Pd51,5Cu36,5Ag10,5Ru1,5 Legierung LHT außerhalb der Ruthenium-Ausscheidungen weitgehend homogen erscheint (siehe Figuren 7 und 9). Das ist ausgehend von den Untersuchungen zum Phasendiagramm im Stand der Technik überraschend, die einen deutlichen Anteil von Silber, Palladium oder binären Silber-Palladium-Verbindungen von mehr als 10 Vol% erwarten lassen würden.

Für die Messungen der Figuren 7 bis 10 wurde ein SuperXG2 Röntgendetektor verwendet, wobei alle 4 Segmente in einem Energiebereich von 20 kV mit einer Dispersion 5 eV verwendet wurden. Die Aufnahmedauer beträgt etwa 125 Minuten (145 Frames, 780x642 Pixel, Verweilzeit 100 μs, Aufnahmedauer pro Frame 51,4 s). Der Datensatz wurde unter Nanobeugungs-Bedingungen aufgenommen, um eine Korrelation mit Regionen mit Überstruktur (hell in DF2) zu ermöglichen. Der Detektor DF2 hat einen Minimal-Durchmesser von 2,3 mm und einen Maximal-Durchmesser von 24 mm

Quantifizierungs-Einstellungen: Standardeinstellungen (Linien/Familien) für jedes Element; empirische Hintergrundkorrektur; Quantifizierung in at%; Vorfiltern (pre-filtering) mit 4 Pixel Durchschnittsfilter (average filter); Nachfiltern (post-filtering) mit 4 Pixel Durchschnittsfilter; alle anderen Einstellungen wurden bei ihren Standardwerten belassen.

Da beim Ag-Map (Figur 7) die (maximal gemessene) Ag-Konzentration niedriger ist als bei den anderen Elementen, endet die Graustufenskala schon bei 17 Atom%. Daher sieht man das Hintergrundrauschen in Figur 7 besser als auf den anderen Maps nach den Figuren 8, 9 und 10.

Die Untersuchungen zeigen, dass bei der untersuchten Zusammensetzung LHT die B2-Kristallstruktur in der Pd51,5Cu36,5Ag10,5Ru1,5 Legierung LHT enthalten ist und sich keine oder nur sehr geringe Mengen (< 1Vol%) von Silber-Ausscheidungen, Palladium-Ausscheidungen oder binären Silber-Palladium-Ausscheidungen in der Pd51,5Cu36,5Ag10,5Ru1,5 Legierung bilden. Der Anteil der B2-Kristallstruktur lässt sich durch die Intensität der von der B2-Kristallstruktur verursachten Reflexe im XRD auf zumindest 5 Vol% der gesamten Pd51,5Cu36,5Ag10,5Ru1,5 Legierung LHT abschätzen. Zumindest sind keine Silber-Ausscheidungen, Palladium-Ausscheidungen oder binäre Palladium-Silber-Ausscheidungen in der Pd51,5Cu36,5Ag10,5Ru1,5 Legierung LHT zu erkennen.

Die in der voranstehenden Beschreibung, sowie den Ansprüchen, Figuren und Ausführungsbeispielen offenbarten Merkmale der Erfindung können sowohl einzeln, als auch in jeder beliebigen Kombination für die Verwirklichung der Erfindung in ihren verschiedenen Ausführungsformen wesentlich sein.

## Patentansprüche

1. Palladium-Kupfer-Silber-Legierung bestehend aus

(a) 40 bis 58 Gew% Palladium,

(b) 25 bis 42 Gew% Kupfer,

(c) 6 bis 20 Gew% Silber,

(d) optional bis zu 6 Gew% zumindest eines Elements, das aus der Gruppe ausgewählt ist, die aus Ruthenium, Rhodium und Rhenium besteht, und

(e) bis zu 1 Gew% Verunreinigungen,

wobei die Palladium-Kupfer-Silber-Legierung eine kristalline Phase mit einer B2-Kristallstruktur enthält und

wobei die Palladium-Kupfer-Silber-Legierung 0 Vol% bis 10 Vol% Ausscheidungen von Silber, Palladium und binären Silber-Palladium-Verbindungen aufweist.

2. Palladium-Kupfer-Silber-Legierung nach Anspruch 1, **dadurch gekennzeichnet, dass** die Palladium-Kupfer-Silber-Legierung

(a) 41 bis 56 Gew% Palladium,

(b) 26 bis 42 Gew% Kupfer und

(c) 7 bis 19 Gew% Silber enthält,

bevorzugt

(a) 41 bis 56 Gew% Palladium,

(b) 26 bis 42 Gew% Kupfer und

(c) 8 bis 18 Gew% Silber enthält,

mehr bevorzugt

(a) 41 bis 56 Gew% Palladium,

(b) 26 bis 42 Gew% Kupfer und

(c) 9 bis 18 Gew% Silber enthält,

noch mehr bevorzugt

(a) 41 bis 56 Gew% Palladium,

(b) 26 bis 42 Gew% Kupfer und

(c) 10 bis 18 Gew% Silber enthält.

3. Palladium-Kupfer-Silber-Legierung nach einem der vorangehenden Ansprüche, **dadurch gekennzeichnet, dass**

die Palladium-Kupfer-Silber-Legierung ein Gewichtsverhältnis von Palladium zu Kupfer von mindestens 1,05 und maximal 1,6 aufweist und ein Gewichtsverhältnis von Palladium zu Silber von mindestens 3 und maximal 6 aufweist.

4. Palladium-Kupfer-Silber-Legierung nach einem der vorangehenden Ansprüche, **dadurch gekennzeichnet, dass**

die Palladium-Kupfer-Silber-Legierung zumindest 0,1 Gew% wenigstens eines Elements, das aus der Gruppe ausgewählt ist, die aus Ruthenium, Rhodium und Rhenium besteht, enthält.

5. Palladium-Kupfer-Silber-Legierung nach einem der vorangehenden Ansprüche, **dadurch gekennzeichnet, dass**

die Palladium-Kupfer-Silber-Legierung Ausscheidungen von Ruthenium, Rhodium, Rhenium oder einer Mischung aus zweien der Elemente ausgewählt aus Ruthenium, Rhodium und Rhenium oder einer Mischung aus Ruthenium, Rhodium und Rhenium enthält, wobei bevorzugt zumindest 90 Vol% der Ausscheidungen an Korngrenzen der Palladium-Kupfer-Silber-Legierung angeordnet sind, besonders bevorzugt zumindest 99 Vol% der Ausscheidungen an Korngrenzen der Palladium-Kupfer-Silber-Legierung angeordnet sind.

6. Palladium-Kupfer-Silber-Legierung nach einem der vorangehenden Ansprüche, **dadurch gekennzeichnet, dass**

die Palladium-Kupfer-Silber-Legierung bis zu 6 Gew% zumindest eines Elements, das aus der Gruppe ausgewählt ist, die aus Ruthenium und Rhodium besteht, enthält, bevorzugt von 0,1 Gew% bis zu 6 Gew% zumindest eines Elements, das aus der Gruppe ausgewählt ist, die aus Ruthenium und Rhodium besteht, enthält, besonders bevorzugt von 1 Gew% bis zu 6 Gew% zumindest eines Elements, das aus der Gruppe ausgewählt ist, die aus Ruthenium und Rhodium besteht, enthält.

7. Palladium-Kupfer-Silber-Legierung nach einem der vorangehenden Ansprüche, **dadurch gekennzeichnet, dass**

die kristalline Phase mit der B2-Kristallstruktur einen Silbergehalt von zumindest 6 Gew% aufweist.

8. Palladium-Kupfer-Silber-Legierung nach einem der vorangehenden Ansprüche, **dadurch gekennzeichnet, dass**

die kristalline Phase mit der B2-Kristallstruktur durch ein Abschrecken der Palladium-Kupfer-Silber-Legierung nach einer Temperaturbehandlung, insbesondere nach einem Tempern, oder nach einem Glühen erhalten wird, und/oder die Palladium-Kupfer-Silber-Legierung durch mehrfache Wärmebehandlungen und mehrfaches Walzen geformt und gehärtet ist, wobei vorzugsweise die Wärmebehandlungen bei einer Temperatur zwischen 700 °C und 950 °C erfolgt und nach der Wärmebehandlung ein Abschrecken erfolgt, wobei während der Wärmebehandlung kein Schmelzen der Palladium-Kupfer-Silber-Legierung erfolgt, und/oder die Palladium-Kupfer-Silber-Legierung schmelzmetallurgisch hergestellt ist und anschließend durch Walzen und Tempern gehärtet ist, wobei vorzugsweise die Palladium-Kupfer-Silber-Legierung eine Härte von mindestens 380 HV0,05 aufweist.

9. Palladium-Kupfer-Silber-Legierung nach einem der vorangehenden Ansprüche, **dadurch gekennzeichnet, dass**
die Palladium-Kupfer-Silber-Legierung eine mittlere Korngröße von maximal 2 μm aufweist.

10. Palladium-Kupfer-Silber-Legierung nach einem der vorangehenden Ansprüche, **dadurch gekennzeichnet, dass**
die Palladium-Kupfer-Silber-Legierung von 0 Vol% bis 5 Vol% Ausscheidungen von Silber, Palladium und/oder binären Silber-Palladium-Verbindungen aufweist, bevorzugt von 0 Vol% bis 2 Vol% Ausscheidungen von Silber, Palladium und/oder binären Silber-Palladium-Verbindungen aufweist, besonders bevorzugt von 0 Vol% bis 1 Vol% Ausscheidungen von Silber, Palladium und/oder binären Silber-Palladium-Verbindungen aufweist, ganz besonders bevorzugt keine Ausscheidungen von Silber, Palladium und/oder binären Silber-Palladium-Verbindungen aufweist.

11. Formkörper bestehend aus einer Palladium-Kupfer-Silber-Legierung nach einem der vorangehenden Ansprüche, wobei bevorzugt der Formkörper die Form eines allgemeinen Zylinders mit beliebiger Grundfläche oder eines spulenartig aufgewickelten allgemeinen Zylinders mit beliebiger Grundfläche aufweist, wobei besonders bevorzugt die Höhe des allgemeinen Zylinders größer ist als alle Abmessungen der Grundfläche des allgemeinen Zylinders, wobei ganz besonders bevorzugt ein Minimalquerschnitt der Grundfläche maximal 500 μm beträgt und ein Maximalquerschnitt der Grundfläche maximal 10 mm beträgt.

12. Prüfnadel oder Schleifkontaktdraht bestehend aus einer Palladium-Kupfer-Silber-Legierung nach einem der Ansprüche 1 bis 10, wobei bevorzugt die Prüfnadel oder der Schleifkontaktdraht zumindest abschnittsweise die Form eines allgemeinen Zylinders mit beliebiger Grundfläche oder eines gebogenen allgemeinen Zylinders mit beliebiger Grundfläche aufweist, wobei besonders bevorzugt ein Minimalquerschnitt der Grundfläche maximal 500 μm beträgt und ein Maximalquerschnitt der Grundfläche maximal 10 mm beträgt und/oder die Prüfnadel an einem Ende an einer Karte befestigt und elektrisch kontaktiert ist und das andere Ende frei schwebend gelagert ist oder der Schleifkontaktdraht an einem Ende an einem elektrischen Kontakt befestigt und elektrisch kontaktiert ist und das andere Ende frei schwebend gelagert ist.

13. Verwendung einer Palladium-Kupfer-Silber-Legierung nach einem der Ansprüche 1 bis 10 oder eines Formkörpers nach Anspruch 11 oder eines Teilstücks eines Formkörpers nach Anspruch 11 oder zum Prüfen von elektrischen Kontakten oder zur elektrischen Kontaktierung oder zur Herstellung eines Schleifkontakts.

14. Verfahren zur Herstellung einer Palladium-Kupfer-Silber-Legierung **gekennzeichnet durch** die chronologischen Schritte:

A) Optional Vorlegieren von Palladium mit wenigstens einem der Elemente ausgewählt aus der Liste Ruthenium, Rhodium und Rhenium mit einem molaren Verhältnis von Palladium zu dem wenigstens einen Element ausgewählt aus der Liste Ruthenium, Rhodium und Rhenium von mindestens 3:1 durch Schmelzen zum Herstellen eine Palladium-Vorlegierung;
B) Legieren von Palladium oder der Palladium-Vorlegierung mit Kupfer und Silber durch Schmelzen und Erstarren in Vakuum und/oder unter einem Schutzgas, wobei mindestens 40 Gew% und maximal 58 Gew% Palladium oder mindestens 40 Gew% und maximal 64 Gew% Palladium-Vorlegierung, mindestens 25 Gew% und maximal 42 Gew% Kupfer und mindestens 6 Gew% und maximal 20 Gew% Silber eingewogen werden;
C) Mehrfache Bearbeitung durch Glühen bei einer Temperatur von mehr als 750 °C für wenigstens 10 Minuten und anschließendem Abschrecken und anschließendem Walzen;
D) Walzen zum Erreichen einer Enddicke von maximal 100 μm;
E) Abschlussglühen bei einer Temperatur zwischen 250 °C und 600 °C für einen Zeitraum von wenigstens 1 Minute.

15. Verfahren nach Anspruch 14, **dadurch gekennzeichnet, dass**

in Schritt B) ein Gewichtsverhältnis von Palladium zu Kupfer von mindestens 1,05 und maximal 1,6 und ein Gewichtsverhältnis von Palladium zu Silber von mindestens 3 und maximal 6 eingewogen wird, und/oder
in Schritt B) das Schmelzen durch Induktionsschmelzen oder durch Vakuuminduktionsschmelzen erfolgt, und/oder
in Schritt B) als Schutzgas ein Edelgas, insbesondere Argon, verwendet wird, vorzugsweise mit einem Partialdruck zwischen 10 mbar und 100 mbar, und/oder
in Schritt B) das Erstarren durch Abgießen in einer Kupferkokille durchgeführt wird, insbesondere in einer ungekühlten Kupferkokille durchgeführt wird, wobei vorzugsweise die Temperatur der Schmelze vor dem Abgießen weniger als 100 °C über der Schmelztemperatur der Palladium-Kupfer-Silber-Legierung liegt.

16. Verfahren nach einem der Ansprüche 14 oder 15, **dadurch gekennzeichnet, dass**

in Schritt C) das Abschrecken in Wasser durchgeführt wird, und/oder
in Schritt C) das Glühen bei einer Temperatur zwischen 850 °C und 950 °C durchgeführt wird, bevorzugt bei einer Temperatur von 900 °C durchgeführt wird und/oder
in Schritt E) das Abschlussglühen bei einer Temperatur zwischen 300 °C und 450 °C erfolgt, bevorzugt bei einer Temperatur zwischen 360 °C und 400 °C erfolgt.

Figur 1

Figur 2

EP 4 234 733 A1

Figur 3

Figur 4

Figur 5

Figur 6

Figur 7

Figur 8

Figur 9

Figur 10

200 nm

Figur 11

Figur 12

EP 4 234 733 A1

Europäisches Patentamt
European Patent Office
Office européen des brevets

## EUROPÄISCHER RECHERCHENBERICHT

**Nummer der Anmeldung**

EP 22 15 9089

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| E | EP 3 960 890 A1 (HERAEUS DEUTSCHLAND GMBH & CO KG [DE]) 2. März 2022 (2022-03-02) * Absätze [0060] – [0075]; Abbildungen 1-4; Tabelle 1 * ----- | 1-13 | INV. C22C5/04 C22C9/00 C22F1/14 G01R1/067 C22C30/00 |
| X | US 2017/218481 A1 (KLEIN ARTHUR S [US] ET AL) 3. August 2017 (2017-08-03) * Absätze [0055] – [0059]; Tabellen 1,2 * ----- | 1-16 | |
| X | US 2021/310103 A1 (TAKAHASHI MAKOTO [JP] ET AL) 7. Oktober 2021 (2021-10-07) * Absätze [0040] – [0056]; Beispiele 1-2, 2-2; Tabellen 1,2 * ----- | 1-8, 11-13 | |
| X | CN 112 063 879 A (KUNMING GUIYAN NEW MATERIAL TECH CO LTD) 11. Dezember 2020 (2020-12-11) * Absätze [0025] – [0040]; Beispiele 1,2 * ----- | 1-9, 11-13 | |

**RECHERCHIERTE SACHGEBIETE (IPC)**

C22C
G01R
C22F

Der vorliegende Recherchenbericht wurde für alle Patentansprüche erstellt

| Recherchenort | Abschlußdatum der Recherche | Prüfer |
|---|---|---|
| Den Haag | 30. August 2022 | Barenbrug-van Druten |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 22 15 9089

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

30-08-2022

| Im Recherchenbericht angeführtes Patentdokument | Datum der Veröffentlichung | Mitglied(er) der Patentfamilie | Datum der Veröffentlichung |
|---|---|---|---|
| EP 3960890 A1 | 02-03-2022 | CN 114107721 A | 01-03-2022 |
| | | EP 3960890 A1 | 02-03-2022 |
| | | JP 2022041921 A | 11-03-2022 |
| | | KR 20220029533 A | 08-03-2022 |
| | | TW 202217012 A | 01-05-2022 |
| | | US 2022064761 A1 | 03-03-2022 |
| US 2017218481 A1 | 03-08-2017 | CN 108699629 A | 23-10-2018 |
| | | CN 113249608 A | 13-08-2021 |
| | | DE 112017000561 T5 | 31-10-2018 |
| | | JP 7084877 B2 | 15-06-2022 |
| | | JP 2019508592 A | 28-03-2019 |
| | | KR 20190010527 A | 30-01-2019 |
| | | TW 201726929 A | 01-08-2017 |
| | | TW 202111133 A | 16-03-2021 |
| | | US 2017218481 A1 | 03-08-2017 |
| | | US 2019330713 A1 | 31-10-2019 |
| | | WO 2017132504 A1 | 03-08-2017 |
| US 2021310103 A1 | 07-10-2021 | CN 112739836 A | 30-04-2021 |
| | | JP 6734486 B2 | 05-08-2020 |
| | | JP WO2019194322 A1 | 30-04-2020 |
| | | KR 20210055099 A | 14-05-2021 |
| | | TW 201940708 A | 16-10-2019 |
| | | US 2021310103 A1 | 07-10-2021 |
| | | WO 2019194322 A1 | 10-10-2019 |
| CN 112063879 A | 11-12-2020 | KEINE | |

Für nähere Einzelheiten zu diesem Anhang : siehe Amtsblatt des Europäischen Patentamts, Nr.12/82

EPO FORM P0461

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140266278 A1
- US 20100194415 A1
- US 1913423 A
- GB 354216 A

- US 2014377129 A1
- US 5833774 A
- EP 20193903 A
- US 10385424 B2

**In der Beschreibung aufgeführte Nicht-Patentliteratur**

- *Journal of Phys. Chem. Ref. Data,* 1977, vol. 6 (3), 647-650
- Einführung in die Elektronenmikroskopie Verfahren zur Untersuchung von Werkstoffen und anderen Festkörpern. **PROF. DR. ECKARD MACHERAUCH ; PROF. DR. VOLKMAR GEROLD.** Werkstoffkunde Grundlagen Forschung Entwicklung. Vieweg Verlag, 1970, vol. 1, 91

- Cu-Pd (Copper-Palladium) P.R. Subramanian, D.E. Laughlin, Phase Diagram Evaluations: Section II, Seite 236, Tabelle 7 ''Lattice Parameters of Ordered CsCI-Type CuPd. *Journal of Phase Equilibria,* 1991, vol. 12 (2